# EUROPEAN PATENT APPLICATION

(11) **EP 4 550 016 A1**
(43) Date of publication of application: **07.05.2025**
(21) Application number: 24210081.6
(22) Date of filing: 31.10.2024
(51) Int. Cl.: G02B 6/42, H01L 25/16

(54) **OPTICAL PACKAGES WITH LED INTERCONNECTS**

(30) Priority: 31.10.2023 US 202363546668 P; 28.10.2024 US 202418928505
(71) Applicant: Google LLC, Mountain View, CA 94043 (US)
(72) Inventor: MOHAMMED, Ilyas, Mountain View, California, 94043 (US)
(74) Representative: Betten & Resch

(57) **Abstract**

A chip package assembly is disclosed that includes an integrated circuit chip and an optical interconnect system. The optical interconnect system has a first optical transmitter having a plurality of first microLEDs and a first optical receiver having a plurality of light sensors. The first optical transmitter and first optical receiver communicate with a respective second external optical receiver and second external optical transmitter of one or more external chip package assemblies. The external optical transmitter transmits an unmodulated optical light signal to the light sensor indicating whether first microLEDs of the external optical transmitter are in the first "on" state or the first "off' state. The light sensors convert the received and second corresponding unmodulated optical light signal to an electrical signal.

## Description

### CROSS REFERENCE TO RELATED APPLICATIONS

The present application claims the benefit of the filing date of U.S. Provisional Patent Application No. 63/546,668, filed October 31, 2023, the disclosure of which is hereby incorporated herein by reference.

### BACKGROUND

Computing performance not only depends on the speed of executing tasks but also on the exchange of data. The exchange of data is further dependent on the performance of interconnects in terms of speed, power, bandwidth, and size, in addition to other factors. Two commonly used interconnects are electrical and optical interconnects. Electrical interconnects typically provide connections between short distances, as they offer size, bandwidth, and cost advantages. Optical interconnects are typically used over longer distances and offer high speed data transmission and power advantages. Interconnects within a package or package-to-package on a board are often electrical, whereas interconnects from a rack/cabinet of boards to another rack/cabinet that may be located in the same room or in a different country are commonly optical interconnects.

Optical interconnects can increase bandwidth while reducing density and power consumption in high performance data communication systems. With the need for higher speed and lower power consumption, optical interconnects can be designed to provide connections for shorter distances, such as from one board to another board. Extensive development is also occurring to implement optical interconnects within a chip package. Despite developments in current industry approaches, improvements to optical interconnects are needed.

### BRIEF SUMMARY

The present disclosure is directed to improved optical interconnect systems and packages incorporating such optical interconnect systems. According to an aspect of the disclosure, an optical interconnect system, chip packages incorporating optical interconnect systems, as well as larger systems that include multiple chip packages may include a substrate; an integrated circuit ("IC") chip overlying the substrate; an optical transmitter that includes a multiplicity of microLEDs that are electrically connected to the IC chip; an optical transceiver that includes a multiplicity of light sensors; and a fiber optic bundle with a plurality of fiber optic elements, each pairing one microLED in one first chip package to one or more light sensors of a second chip package external to the first chip package. But, in other examples, the fiber optic bundle can pair a microLED and a light sensor in the same chip package. Each microLED includes at least one of two states: an "on" state and an "off' state. The "on" state indicates that the microLED is emitting or emanating light and the "off" state indicates that the microLED is not emitting or emanating light. In some examples, a determination that the microLED is not emanating light may be based on whether the emanating light meets a predetermined or threshold amount of light. An unmodulated optical light signal indicating the state of the microLED is transmitted from the microLED to a corresponding light sensor of a light sensor array of an external chip package through a connecting fiber optic element. Each light sensor senses the unmodulated optical light signal and can detect the state of the microLED in the first chip package. A light sensor can convert the unmodulated optical light signal to an electrical signal. In some examples, the IC chip may be a high-power chip, such as a processing chip. In some examples, a control device can convert the electrical signal and transmit the signal to another component, device, or IC chip in the same or a different package or system.

According to an aspect of the disclosure, the chip package assembly includes a substrate; an integrated circuit ("IC") chip coupled to the substrate; and an optical interconnect system. The optical interconnect system further includes a first optical transmitter and an optical receiver. The first optical transmitter includes a first micro light emitting diode ("microLED") array electrically connected to the IC chip and comprising a plurality of first microLEDs. The first microLEDs has two states comprising a first "on" state and a second "off state. Each of the first microLEDs transmit a first unmodulated optical light signal indicating whether each of the first microLEDs is in the first "on" state or the first "off" state. The optical receiver comprises a light sensor array that further comprises a plurality of light sensors that are configured to sense optical light. Each of the light sensors is configured to receive a second corresponding unmodulated optical light signal from a second external optical transmitter external to the chip package assembly, the second external optical transmitter comprising a plurality of second external microLEDs, wherein each of the second external microLEDs transmits the second corresponding unmodulated optical light signal indicating whether the second external microLED transmitting the second corresponding unmodulated optical light signal is in a second "on" state or a second "off state." The light sensors convert the received and second corresponding unmodulated optical light signal to an electrical signal.

According to another aspect of the disclosure, an optic system for interconnecting two or more chip package assemblies comprises the chip package assembly described above in Paragraph [0005], and a second chip package assembly. The chip package assembly is a first chip package assembly, the IC chip is a first chip, the light sensor array is a first light sensor array, the first light sensor is a plurality of first light sensors, the optical receiver is a first optical receiver, the electrical signal is a first electrical signal, and the interconnect system is a first interconnect system. The second chip package assembly includes a second IC chip and a second interconnect system. The second interconnect system further includes a second external optical receiver electrically connected to the second IC chip and the second external optical transmitter. The second external optical receiver includes a second external light sensor array comprising a plurality of external second light sensors and the plurality of external second light sensors are configured to sense optical light. The second external optical transmitter may be electrically coupled connected to the second IC chip.

According to an aspect of the disclosure, an optical interconnect system includes an integrated circuit ("IC") chip; an optical transmitter; an optical transceiver; a fiber optic bundle; and a control device. The optical transmitter includes a light emitting diode ("LED") array electrically connected to the IC chip. Each LED of the LED array has two states including an "on" state and an "off" state. An optical transceiver may include a light sensor array that further includes a plurality of light sensors. Each light sensor in the plurality of light sensors may be configured to sense optical light. The fiber optic bundle includes a plurality of fiber optic elements. Each fiber optic element in the fiber optic bundle pairs an LED in the LED array to a light sensor in the light sensor array, such that each LED in the LED array communicates with a corresponding light sensor in the light sensor array through a single fiber optic element. Each LED in the LED array transmits, through the fiber optic element, an unmodulated optical light signal that indicates whether each LED in the LED array is in an "on" state or an "off' state. Corresponding light sensors in the light sensor array receive the unmodulated optical light signal. Each of the light sensors converts the received and unmodulated optical light signal to an electrical signal. The control device includes one or more processors configured to receive the electrical signal from each of the light sensors in the light sensor array; and determine whether each LED is in the "on" state or the "off" state based on the electrical signal received from each of the light sensors in the sensor array.

According to an aspect of the disclosure, a chip package assembly includes a substrate and the optical interconnect system, as described above in paragraph [0007]. The IC chip is a first chip and overlies the substrate. A second IC chip overlies the substrate and is electrically connected to the light sensor. The light sensor may transmit the electrical signal to the second IC chip.

According to another aspect of the disclosure, an optical interconnect system comprises an integrated circuit ("IC") chip; an optical transmitter; an optical transceiver; and a fiber optic bundle. The optical transmitter may include a light emitting diode ("LED") array electrically connected to the IC chip. Each LED of the LED array has an "on" state and an "off" state. An optical transceiver includes a light sensor array that includes a plurality of light sensors. Each light sensor in the plurality of light sensors is configured to sense optical light. A fiber optic bundle may include a plurality of fiber optic elements. Each fiber optic element in the fiber optic bundle pairs an LED in the LED array to a light sensor in the light sensor array, such that each LED in the LED array communicates with a corresponding light sensor in the light sensor array through a single fiber optic element. Each LED in the LED array transmits, through the fiber optic element, an unmodulated optical light signal indicating whether each LED in the LED array is in an "on" state or an "off' state through the fiber optic element and corresponding light sensors in the light sensor array receive the unmodulated optical light signal, wherein each of the light sensors converts the received and unmodulated optical light signal to an electrical signal. For each fiber optic element in the plurality of fiber optic elements, a first end of the respective fiber optic element is directly attached to a surface of the LED to which it is connected.

### BRIEF DESCRIPTION OF THE DRAWINGS

FIG. 1A is a schematic view of an optical interconnect system according to an aspect of the disclosure.
FIG. 1B is a schematic view of an optic system that includes the optical interconnect system of FIG. 1A.
FIG. 2 is a schematic view of components of a chip package assembly that omits certain features for ease of illustration according to an aspect of the disclosure.
FIG. 3 is a schematic view of a chip package assembly incorporating the components of FIG. 2 according to an aspect of the disclosure.
FIG. 4A is a schematic view showing the interconnection between components of the chip package assembly of FIG. 3 according to aspects of the disclosure.
FIG. 4B is a voltage diagram according to an aspect of the disclosure.
FIG. 5A is a schematic view of an example system including the chip package of FIGS. 3-4A according to an aspect of the disclosure.
FIG. 5B is a schematic view of an example system including the chip package of FIGS. 3-4A according to an aspect of the disclosure.
FIG. 5C is a schematic view of an example system including the chip package of FIGS. 3-4A according to an aspect of the disclosure.
FIG. 6 is a schematic top view of a chip package assembly according to an aspect of the disclosure.
FIG. 7 is a cross-sectional view taken across line A-A of FIG. 6 according to an aspect of the disclosure.
FIG. 8 is a schematic cross-sectional view of an enlarged portion of FIG. 7.
FIG. 9 is a cross-sectional view taken across line B-B of FIG. 6 according to an aspect of the disclosure.
FIG. 10 is a schematic cross-sectional view of an enlarged portion of FIG. 9.
FIG. 11 is an alternative schematic cross-sectional view taken across line A-A of FIG. 6 according to an aspect of the disclosure.
FIG. 12 is a schematic cross-sectional view of an enlarged portion of FIG. 11.
FIG. 13 is an alternative schematic cross-sectional view taken across line B-B of FIG. 6 according to an aspect of the disclosure.
FIG. 14 is a schematic cross-sectional view of an enlarged portion of FIG. 13.
FIG. 15 is a schematic cross-sectional view showing an alternative configuration of a chip package assembly according to an aspect of the disclosure.
FIG. 16 is a schematic cross-sectional view showing another configuration of a chip package assembly according to an aspect of the disclosure.
FIG. 17 is a schematic cross-sectional view showing another configuration of a chip package assembly according to an aspect of the disclosure.
FIG. 18 is an example control system for an optical interconnect system according to aspects of the disclosure.
FIG. 19 is an example flow diagram in accordance with aspects of the disclosure.

### DETAILED DESCRIPTION

Optical interconnect systems and chip packages incorporating optical interconnect systems, as well as larger systems that incorporate multiple chip packages with optical interconnect systems are disclosed that simplify electrical-to-optical and optical-to-electrical conversions.

In one example, chip package assembly is disclosed that includes an integrated circuit chip and an optical interconnect system. The optical interconnect system has a first optical transmitter having a plurality of first microLEDs and a first optical receiver having a plurality of light sensors. The first optical transmitter and first optical receiver communicate with a respective second external optical receiver and second external optical transmitter of one or more external chip package assemblies. The external optical transmitter transmits an unmodulated optical light signal to the light sensor indicating whether first microLEDs of the external optical transmitter are in the first "on" state or the first "off" state. The light sensors convert the received and second corresponding unmodulated optical light signal to an electrical signal.

In another example, an interconnect chip package assembly includes a substrate; a microelectronic element, such as a semiconductor chip; and an optical interconnect assembly or system. The optical interconnect system may further include an optical input, such as an array of light sources, which can include, without limitation, LEDs or microLEDs; an optical output, such as an array of sensors, such as, without limitation, photodetectors or photodiodes; and at least one light fiber optic bundle of fiber optic elements. The light source array may serve as an electrical-to-optical interface and the sensor array may serve as an optical-to-electrical interface. In this example, the light source array can generate signal outputs and the package sensor array receives signal inputs. The light source array and the sensor array of the chip package assembly provide optical inputs and outputs for the chip package assembly such that, in this example, they are not directly coupled to one another and do not directly communicate with one another. Instead, as will be discussed in more detail below, the packaged light source array may directly communicate with an external light sensor of an external sensor array that is external to the chip package assembly. The sensor array of the chip package assembly similarly communicates with an external light source array that is external to the chip package assembly. But, in other examples, the light source array and the sensor array may communicate with another.

The number of light sources in the light source array may number in the tens, hundreds, thousands, or more. The number of sensors can correspond to the number of light sources and can also number on the order of hundreds, thousands, or more. A first fiber optic bundle can be attached to the array of light sources and a separate and second fiber optic bundle can be attached to the array of light sensors. Each individual light fiber in the first fiber optic bundle directly connects and pairs an individual light source in the packaged light source array to an external sensor in the external sensor array of another chip package assembly and can transmit light emanating from each light source to the corresponding external sensor.

The light sources will each receive an electrical analog signal that has been converted from a digital signal. Based on the analog signal, the light sources will turn "on" or remain "on" and emanate light or turn "off" or remain "off' and not emanate light. Each light source will transmit an optical light signal, also referred to herein as a "light signal," indicating whether the light source is "on" or "off" at any given point in time. The individual light fibers in the first fiber optic bundle can each carry the light signals from each light source in the first light source array to the corresponding external sensor in the external sensor array.

The sensors in the chip package assembly will each receive the respective unmodulated optical light signals and detect whether the light signals indicate that the light source is in an "on" state or in an "off" state. Each respective light signal may be converted to an analog electrical signal. The analog electrical signals may be converted back to a digital signal.

Incorporating a multiplicity of light sources in the system reduces the data that needs to be pushed through each individual light source. This is because the only data that needs to be transmitted through the optical light signal transmissions to the sensors of an external package is whether the light is "on" or "off" or whether the light is in an "on" state or "off" state. Thus, specific characteristics of the light signal, e.g., frequency, bandwidth, brightness, and the like, have no bearing on the light signal output to the photodiodes. Even if each of the different light signals has different frequencies and bandwidth, these attributes of the signal can be ignored by the sensor. The system is, therefore, configured so that the light signal emitted by the array of light sources to which the photodiodes are connected and received by the photodiodes requires no modulation of the brightness, frequency, wavelength, polarity, and coherence of the light signal.

As a result, this system eliminates the need to control the quality of light emanating from the light source, since these qualities in the light signal no longer need to be measured or accounted for by the sensor. This further improves the optical interconnect packaging. Precise and painstaking alignment of each light fiber to the light source, as well as the need for high-quality and high-cost light fibers to ensure the highest quality transmission of the light signal are no longer required. This further eliminates the need to implement waveguide structures or other processes required for the precise alignment of the fiber optic elements to the light source and sensors. It also eliminates any potential error or inaccuracy resulting from inaccurate modulation of the light signal due to inaccurate alignment or control over the light signal. Instead, each fiber optic element in the first fiber optic bundle can be directly coupled and/or attached to an external array of light sensors of another package, such as LEDs or microLEDs, using known means, such as transparent optical adhesives or the like. Additionally, this can eliminate the need for modulators, amplifiers and other components that take significant power and space, while limiting the bandwidth.

Standard off-the-shelf fiber optic cables may also be implemented for the first and second fiber optic bundles, instead of customized and highly specialized fiber optic cables required to carry specific and high-quality signals, since light quality does not need to be controlled. Further, simple LED and microLED light sources may be implemented, as opposed to high-quality fiber optic illuminators or bright lights required to efficiently focus light into the fibers and that later require frequency modulation and the like. Simple sensors can also be implemented to detect whether the light signal indicates that the LEDs are in an "on" state or in an "off' state. This can eliminate the need to obtain expensive fiber optic sensors that further require precise installation methods and procedures.

The one or more fiber optic bundles may be a collection of multiple thin optical fibers or individual fiber optic elements that are bundled together to transmit light signals. Each fiber optic element in the fiber optic bundles can directly connect or pair a light source and sensor together. In one example, fiber optic bundles will couple each light source in the light source array of a first chip package to an external sensor in the external sensor array of an external package. Similarly, a fiber optic bundle will couple each sensor of the first chip package to an external microLED of an external microLED array of a second chip package external to the first chip package. In some examples, one end of the fiber optic element may be directly attached to the light source and the opposite end of the fiber optic element may be directly attached to a sensor of the external package. Each end may be secured to the light source and light sensor by known means, including an adhesive material that is optically clear. In some examples, the light source may be any LED and the array may include a plurality of LEDs . The LEDs may further include microLEDs. Since the photodiodes are not required to accurately measure light intensity or capture frequency, the photodiodes may be simple sensors. In some examples, the photodiodes may be composed of numerous materials, including, without limitation, silicon, ceramic, germanium, and/or indium gallium arsenide.

Further, the first chip package assembly may include a multiplicity of light sources in the light source array and a corresponding multiplicity of sensors in the sensor array. In some examples, there are hundreds, thousands, or even more light sources and corresponding sensors in the respective arrays. The number of light sources in the light source array can equal the number of sensors in the sensor array, such that there is a one-to-one correspondence between the number of photodiodes and the number of light sources. As noted above, the increased number of light sources and corresponding photodiodes can compensate for the fact that each light signal only carries and transmits minimal data, such that the light signal does not need to be modulated for frequency, brightness, or other characteristics of the light signal.

In one example, to determine whether the light source is in the "on" state or the "off" state, bit values can be assigned to the signal being transmitted by the light source to indicate whether the light source is in the "on" state or the "off' state. A bit value of "0" can indicate that the light source is in the "off" state and a value of "1" can indicate that the light source is in the "on" state, but any values can be arbitrarily assigned to each state. Each light source may have a ground terminal and a power terminal respectively set for two voltage levels. For example, the ground terminal may be set to a zero voltage and the power terminal may be set at a nominal non-zero voltage, in which the voltage may be greater than zero, such as 1V or more than 1V, such as, for example, without limitation, 2V, 3V, 4V or 5V. The voltage of a single ground terminal may be, for example, fixed at 0V in time, whereas the voltage of an individual power terminal will vary over time. This modulation in time may comprise switching between a zero voltage and a nominal voltage indicating that a digital bit is either a zero ("0") or one ("1"). When the microLED is in the "on" state, the power terminal will have a nominal non-zero voltage and the digital bit can be assigned a one ("1"). When the light source is in the "off" state, the power terminal will have a 0 voltage or a voltage below 0 or approaching 0 and the digital bit is a zero ("0").

Based on the signal, each light source in the first and second chip packages will be in the "on" state and emanate light or the "off" state and emanate no light. The light source will emanate or emit light (or no light) and a light signal through first ends of the fiber optic elements which are connected to each of the light sources at an opposite end to corresponding to light sensors. In this example, there will be a second set of light sensors external to the chip package.

Each light sensor in the sensor array of the first chip package may sense the received optical signal from an external microLED in the external microLED arrays of a second chip package through the fiber optic element, the light sensors may also include power and ground terminals. In one example, the ground terminal may be set at zero voltage and the power terminal may be set for a nominal non-zero voltage, which can include without limitation, a voltage such as 1V, 2V, 3V, 4V, 5V, or more. The amount of current at a given point in time can be sensed to determine if light is being received at the light sensor. Depending on whether the light source is "on" or "off," the light sensor can receive a signal of either "0" or "1" or any other arbitrary assignment of two different numbers. Once the light sensor receives the unmodulated optical light signal carrying the "0" or "1", the analog light signal can be converted to a digital signal through a digital processor or the like to determine whether the signal is a "1" and the light source is "on" or whether the signal is a "0" and the light source is "off." Each light source and photodiode can receive its own signal and may receive its signal at a same or different time, such that signals transmitted by photodiodes may differ.

### EXAMPLE OPTICAL INTERCONNECT SYSTEMS AND CHIP PACKAGING ASSEMBLIES

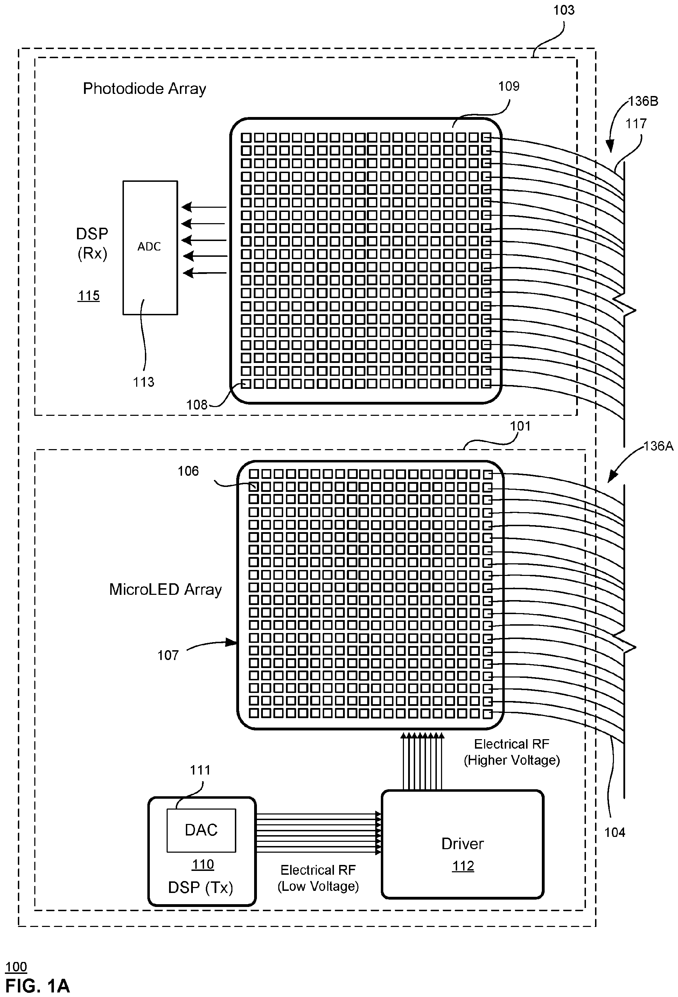

FIG. 1A illustrates a schematic diagram illustrating an example optical interconnect system 100 according to an aspect of the disclosure. The interconnect system 100 includes an optical output, such as parallel optical transmitter 101 and an optical input, such as parallel optical transceiver 103, both of which communicate with and are coupled to components external to system 100. The diagram illustrates the electrical-to-optical conversion of a digital signal using light sources, such as LEDs, and in some examples microLEDs 106 within a light source array 107 of parallel optical transmitter 101, sensors, such as photodiodes 108 within sensor array 109 of optical transceiver 103, and a first fiber optic bundle 136A comprising fiber optic elements 104 that extend from each microLED 106 in light source array 107 and a second fiber optic bundle 136B comprising fiber optic elements 117 that extend from each photodiode 108 in the sensor array 109. As will be discussed in more detail below, first fiber optic elements 104 of a first fiber optic bundle 136A optically connect microLEDs 106 in light source array 107 of system 100 to photodiodes of another system that is external to system 100. Similarly, second fiber optic elements 117 of a second fiber optic bundle 136B connect photodiodes 108 of system 100 to microLEDs of another system that is external to system 100. In this configuration, fiber optic elements do not optically connect sensor array 109 and light source array 107 of system 100 together, but in other examples, if desired, a set of fiber optic elements can alternatively connect one or more photodiodes 108 in sensor array 109 with a corresponding microLED 106 in light source array 107. For ease of illustration and discussion, only a first row of microLEDs 106 and photodiodes 108 is shown coupled to fiber optic elements 104 but it is to be appreciated that fiber optic elements 104 are connected to each microLED 106 and photodiode 108 in the respective light source and sensor arrays 107, 109 and will be illustrated in later examples.

As shown, digital signal processor 110 can process a digital signal and convert the signal to an analog signal through digital-to-analog converter 111. Driver 112 receives the input analog signal which drives microLEDs 106 in light source array 107 to turn "on" or remain "on" *(i.e.,* emit light) or turn "off" or remain "off' (*i.e.,* no emission of light). Light subsequently emitted by the microLEDs 106 need not be coherent, as the light will only carry an "on" or "off" signal. The characteristics of the emitted light, e.g., frequency, bandwidth, etc., will have no bearing on the output generated by microLEDs 106. Consequently, there is no need to further modulate the frequency or other characteristics of the light signal emitted by a microLED or to exert strict control over the quality of light being emitted from microLEDs 106 through fiber optic elements 104. Photodiodes 108 are configured to detect the light signal indicating whether a microLED to which it is connected is in an "on" state or an "off" state.

MicroLED 106 will be "on" or in an "on" state when the microLED 106 emits light or a predetermined threshold amount of light. The light emitted by microLED 106 does not need to be a high-quality light and can be, for example, a simple white light that contains electromagnetic radiation at all wavelengths in the visible range of the spectrum. When microLED 106 is "on" or in an "on" state, power will be provided to the microLED to ensure the microLED is "on." When microLED 106 is "off" or in an "off" state, the microLED emits no light and there is no power provided to the microLED to power the light.

Since only an "on" or "off" signal is output or transmitted from each microLED 106 through fiber elements 104, a multiplicity of microLEDs 106 must be provided in the light source array 107 to account for bandwidth and in order to obviate the need for signal modulation of the frequency and/or other components of light. According to aspects of the disclosure, microLEDs 106 may include at least 100 microLEDs, and may further number in the hundreds, thousands, or even more. In one example, as shown in FIG. 1A, array 107 includes approximately 400 microLEDs 106. Based on the need to implement numerous light sources, a system that includes only a few light sources in the light source array, such as, for example, only one light source or microLED or tens of microLEDs, will be insufficient, as modulation of the light signal will be required to process light signals emitted by so few microLEDs.

MicroLEDs 106 may be manufactured according to known methods, and in some examples may be micrometer-scale gallium-nitride LEDs. Each microLED 106 may be separate and distinct from other microLEDs 106 in light source array 107 and each microLED 106 can have its own ground terminal and power terminal. Based on ground, values can be assigned to the signals to indicate that the microLED is in an "off' state and not emitting light or that the microLED is in an "on" state and emitting light. In one example, which will be described in more detail below, the signal may have a value, such as "0," when the microLED is in the "off" state and there is no current to power the light. When the microLED is in the "on" state, the signal can be assigned an arbitrary value, such as "1," indicating that there is current and power. While the present example focuses on microLEDs, it is to be appreciated that LEDs and/or other alternative light sources may be implemented within the system.

Transceiver 103 includes an array 109 of sensors 108. The sensors 108 are only required to detect whether microLEDs to which they are connected, such as microLEDs of another system or package (which may be substantively the same as microLEDs in system 100) are "on" or "off," *i.e.*, an unmodulated optical light signal. Simple sensors may therefore be used in array 109. In one example, photodiodes 108 of system 100 may be used to convert light transmitted from an external microLED of another system and through fiber optic element 117 into an electrical signal based upon current or voltage through photodiodes 108. The photodiodes 108 may transmit the electrical signal to an analog-to-digital converter 113, which may be configured to convert the electrical signal to a digital signal. A digital signal processor 115 may further process the digital signal. Photodiodes may be manufactured from materials such as, for example, silicon, germanium, or other semiconductor compounds that possess properties of both conductors and insulators.

The components in optical interconnect system 100 provide only one example of an optical interconnect system that includes an optical input and an optical output. Although the digital signal processor (DSP) 110, digital-to-analog converter 111, driver 112, and various elements are shown as part of the optical interconnect system 100, it is to be appreciated that such elements can instead be part of a separate system that will communicate with components of an optical interconnect system containing at least a photo diode array, a microLED array, and fiber optic elements or connectors that can couple the respective light source and sensor arrays 107, 109 to corresponding sensor and light source arrays of an external system. Similarly, additional subsystems or components may communicate with components in optical interconnect system 100 to process or control one or more aspects of optical interconnect system 100. Further, DSPs 110, 115, digital-to-analog converter 111, driver 112, and the transmission of signals by microLEDs and photodiode arrays can be controlled and/or operated by one or more microelectronic elements, such as semiconductor chips, optical chips, processor chips, memory chips, special function chips, and the like (collectively "chip" or "chips" or "IC chips") and may be part of the same optical interconnect system or a different system that communicates with optical interconnect system 100.

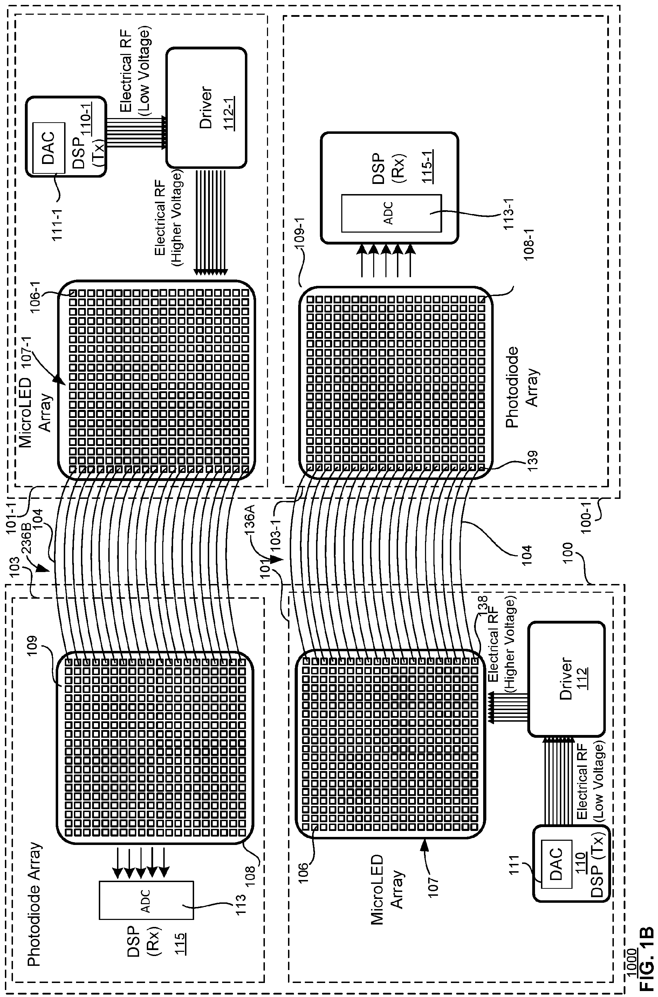

With reference to FIG. 1B, a larger system 1000 includes optical interconnect system 100, which is also referred to as first optical interconnect system 100, and a second optical interconnect system 100-1. Second optical interconnect system 100-1 may be identical to system 100 and include the same components. In particular, system 100-1 may include an optical output, such as parallel optical transmitter 101-1 and an optical input, such as parallel optical transceiver 103-1, both of which communicate with and are coupled to components external to system 100-1. The diagram of system 100-1 illustrates the electrical-to-optical conversion of a digital signal using light sources, such as an LED, and in some examples microLEDs 106-1 within a light source array 107-1 of parallel optical transmitter 101-1, and sensors, such as photodiodes 108-1, within sensor array 109-1 of optical transceiver 103-1. As the components in system 100-1 are identical to the components in system 100, a full discussion of these components is not discussed.

In this example, first fiber optic elements 104 couple parallel optical transmitter 101 of system 100 with parallel optical transceiver 103-1 of system 100-1. Individual fiber optic elements 104 connect and pair each microLED 106 in light source array 107 of system 100 directly to a corresponding photodiode 108-1 in sensor array 109-1 of system 100-1, as well as transmit the light and signal from microLEDs 106 to photodiodes 108-1. For ease of illustration, only a first column of microLEDs 106 and photodiodes 108-1 are shown coupled together by fiber optic elements 104, but it is to be appreciated that each microLED 106 in light source array 107 of system 100 may be coupled to a corresponding photodiode 108-1 in sensor array 109-1 of system 100-1 by a fiber optic element 104, such that there is a one-to-one ratio between the number of microLEDs 106 in system 100 and photodiodes 108-1 in system 100-1. In other examples, there may be more microLEDs 106 than photodiodes 108-1 and vice versa. In such examples, several fiber optic elements may extend from multiple microLEDs, but may be attached to the same or a fewer number of photodiodes and vice versa.

Photodiodes 108-1 in system 100-1 are configured to detect the light signals that are emitted from and transmitted by external light sources or light sources external to system 100-1. In this example, photodiodes 108-1 detect or receive unmodulated light signals from microLEDs 106 of system 100 that indicate whether microLEDs 106 are in an "on" state or in an "off' state. As shown, first end 138 of first fiber optic element 104 of fiber optic bundle 136A is coupled to microLEDs 106 of system 100 and a second end 139 of first fiber optic element 104 of fiber optic bundle 136A can be coupled to external photodiode 108-1 of system 100-1. In some examples, first and second ends of fiber optic element may be directly attached to microLEDs or photodiodes. External photodiodes 108-1 detect whether microLEDs 106 of system 100 are in an "on" state or in an "off' state based on the unmodulated optical light signal received from microLEDs 106. In this example, photodiodes 108-1 of system 100-1 may be used to convert light or light signals transmitted from microLED 106s through fiber optic elements 104 into an electrical signal based upon current or voltage through photodiodes 108-1. Photodiodes 108-1 may transmit the electrical signal to an analog-to-digital converter 113-1, which may be configured to convert the electrical signal to a digital signal. A digital signal processor 115-1 may further process the digital signal. Photodiodes 108-1 may be manufactured from materials, such as, for example, silicon, germanium, or other semiconductor compounds that possess properties of both conductors and insulators.

Transceivers 103, including photodiodes 108 of system 100 that may similarly be coupled to external microLEDs 106-1 of system 100-1 through fiber optic elements 117. Although for ease of illustration only a first column of external microLEDs 106-1 and photodiodes 108 are shown coupled together by fiber optic elements 117, it is to be appreciated that fiber optic elements will extend between each photodiode 108 of system 100 and microLED 106-1 of system 100-1, such that there is a one-to-one ratio between the number of microLEDs 106-1 in system 100-1 and photodiodes 108 in system 100. Similarly, each microLED 106 of system 100 and photodiode 108-1 of system 100-1 will be coupled together by fiber optic elements so as to have a one-to-one ratio between the number of microLEDs 106 of system 100 and photodiodes 108-1 of system 100-1.

It is to be appreciated that in this example, the input (microLEDs 106) and output (photodiodes 108) of system 100 are respectively coupled to the output (e.g., photodiodes 108-1) and input (microLEDs 106-1) of system 100-1. In other examples, only one set of inputs or outputs may be coupled together between system 100 and 100-1. For example, an input of system 100 and an output of system 100-1 may be coupled together, but an output of system 100 may instead be coupled to an input of a different system or a system other than system 100-1. Similarly, output of system 100 may be coupled to input of system 100-1, but the input of system 100 may be coupled to an output of a different system. Examples of such systems will be further discussed below.

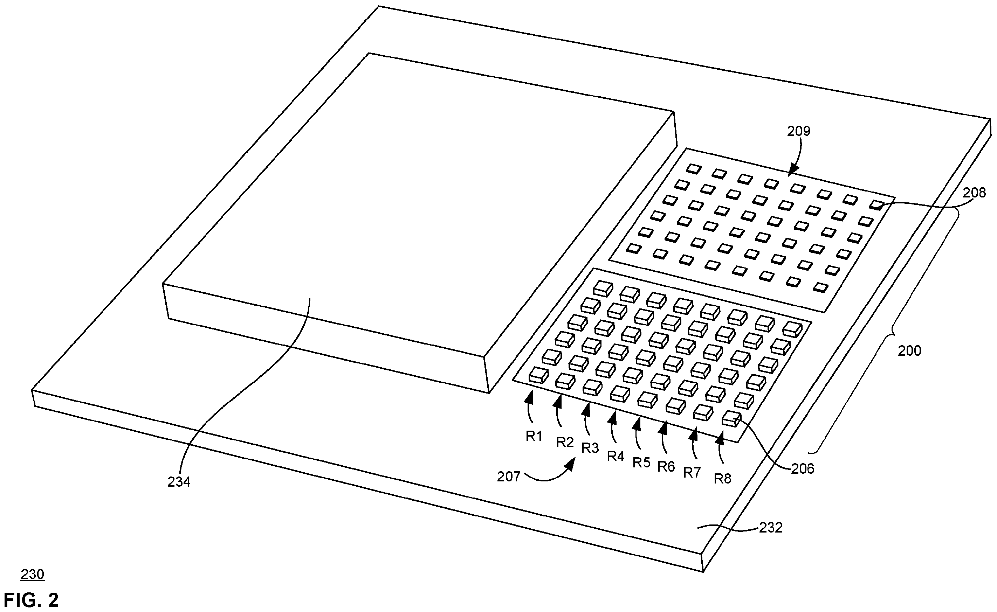

Optical interconnect systems, such as optical interconnect systems 100 and 100-1, can be packaged, as well as incorporated into a larger microelectronic packaging assembly in any one of a number of different configurations. FIGS. 2-3 illustrate a simple schematic example of an optical interconnect package assembly or a chip package assembly 230 that incorporates both an optical interconnect system and a chip, with FIG. 2 depicting schematic components of assembly 230 without the optical interconnects for ease of illustrating components hidden by the optical interconnects. Package assembly 230 includes a substrate 232, a microelectronic element, such as a semiconductor chip or integrated circuit chip, which in this example may be an IC chip or optical chip 234 that can perform the electrical-to-optical conversions and optical-to-electrical conversions, and an optical interconnect system 200, that can include, without limitation, a light source array 207 (FIG. 2), including microLEDs 206, a sensor array 209 of sensors, such as photodiodes 208, and fiber optic elements 236.

As shown in FIG. 2, there are eight rows of microLEDs 206 and photodiodes 208: first row R1, second row R2, third row R3, fourth row R4, fifth row R5, sixth row R6, seventh row R7, and eighth row R8, but any number of rows and arrangement of microLEDs 206 and photodiodes 208 may be implemented. For ease of illustration and to assist with the description, only a handful of microLEDs 206 and photodiodes 208 are shown, but as previously described, the number of microLEDs 206 and corresponding photodiodes 208 must be numerous and can be increased to obviate the need to modulate frequency of signals transmitted from the microLEDs. In some examples, there will be at least one hundred LEDs or microLEDs 206 and there may be an equal number of photodiodes 208, but in other examples the microLEDs 206 and photodiodes 208 may number in the hundreds, thousands, or even more. In some examples, there may be between 16 and 64 microLEDs, or between 64 and 256 microLEDs, or between 256 and 1024 microLEDs. In other examples, there may be 10 or more microLEDs, 16 or more microLEDs, 64 or more microLEDs, or 256 or more microLEDs. There may also be a thousand or more microLEDs. There may also be one photodiode for each microLED to which it is connected, such that there are an equal number of microLEDs and photodiodes to which the microLEDs are connected.

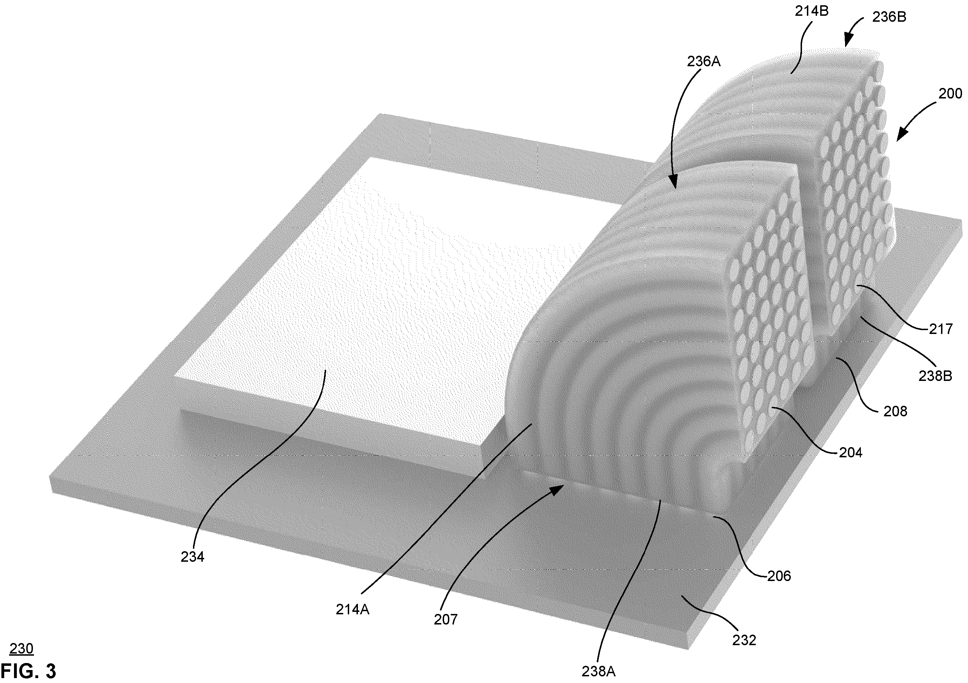

Fiber optic bundles may be directly or indirectly attached to the light source array 207 and light sensor array 209. With reference to FIG. 3, a first fiber optic bundle 236A can be directly attached to microLEDs 206 and a second fiber optic bundle 236B can be attached to photodiodes 208. In this example, fiber optic bundle 236A incorporates all of the needed fiber optic elements 204 for microLEDs 206 and fiber optic bundle 236B incorporates all of the needed fiber optic elements 217 for photodiodes 208 in chip package assembly 230. For example, fiber optic bundles 236A, 236B each include forty-eight (48) fiber optic elements 204, 217, such that the number of fiber optic elements 204 in fiber optic bundle 236A corresponds to the respective number of microLEDs 206 in chip package 230. The number of fiber optic elements 217 in fiber optic bundle 236B can correspond to the number of photodiodes 208 in chip package 230. In other examples, either or both of fiber optic bundles 236A, 236B may incorporate a smaller number of fiber optic elements 204, 217 that collectively total 48 fiber optic elements.

Each fiber optic element 204 in bundle 236A can directly connect microLEDs 206 in light source array 207 (FIG. 2) to corresponding photodiodes external to chip package 230. Each fiber optic element 217 in bundle 236B directly connects one photodiode 208 in sensor array 209 (FIG. 2) to a corresponding microLED external to chip package 230. As shown, first ends 238A of fiber optic element 204 within fiber optic bundle 236A may be directly attached to microLEDs 206 and second ends may be directly attached to a component external to the package, such as light sensors or photodiodes of another chip package. First ends 238B of fiber optic element 217 of second fiber optic bundle 236B may be similarly directly or indirectly attached to photodiodes 208 in chip package 230 and second ends may be attached to an external microLED, which is external to the package. In one example, an adhesive material that is optically clear may be used to provide direct attachment of first ends 238A, 238B of fiber optic elements 204, 217 to respective microLEDs 206 and photodiodes 208. In other examples, fiber optic bundle 236A may be attached to a mechanical structure that can be coupled to light source array 207 and fiber optic bundle 236B may be attached to a mechanical structure that can be coupled to light sensor array 209. The same materials or structure may also be used to attach second ends of fiber optic elements 204, 217 of fiber optic bundles 236A, 236B to components external to the chip package 230.

The overall length of each fiber optic bundle 236A, 236B can vary widely. Fiber optic bundles 236A, 236B may have a length greater than 10mm and less than 100mm. In still other examples, the overall length of the fiber optic bundles 236A, 236B may be greater than 100 mm and less than 1m. In an example where it may instead be desired to connect microLEDs 206 directly to photodiodes 208 within the same package 230, a single fiber optic bundle with a plurality of fiber optic elements may extend directly between the microLEDs 206 and the photodiodes 208.

The fiber optic elements may carry a signal indicating whether the microLED to which the fiber optic elements are attached are in the "on" state and emitting light or in the "off" state and not emitting light.

For example, the only signal that each fiber optic element 204 in fiber optic bundle 236A needs to carry is whether the microLED 206 to which a first end 238A of each fiber optic element 204 is attached is in the "on" state and emanating light or in the "off" state and not emanating light. Respective first end 238A of fiber optic element 204 can be coupled to corresponding microLEDs 206 and second ends of fiber optic elements 204 can be coupled to photodiodes of an external chip package that is external to chip package 230. In some examples, ends 238A and second ends may be directly attached to respective microLEDs 206 and photodiodes of an external chip package. In this configuration, first ends 238A of fiber optic elements 204 need only be generally aligned with microLEDs 206 when attached to microLEDs 206 and the second ends of fiber optic element 204 need only be generally aligned with corresponding photodiodes of another package when attached to the photodiode of another package. This obviates the need to orient fiber optic elements at certain angles or precisely align fiber optic elements with microLEDs 206, or to otherwise position the fiber optic elements to receive and transmit large amounts of data. This configuration can further obviate the need for additional wave guides or structure in the chip packaging assembly 230 to ensure that light traveling from microLEDs 206 to photodiodes of another package follows an accurate path, as well as the need to control the characteristics and quality of light emanating from microLEDs 206.

First ends 238B of fiber optic elements 217 are similarly coupled to or attached to photodiodes 208 of chip package assembly 230 and the second ends of fiber optic elements 217 can be coupled or attached to microLEDs of another package assembly external to chip package assembly 230. In this configuration, fiber optic elements 217 will also be carrying signal indicating whether a microLED external to chip packaging assembly 230 is in the "on" state and emanating light or in the "off" state and not emanating light. This configuration also obviates the need to orient fiber optic elements 217 at certain angles or to precisely align the microLEDs of the external chip package with fiber optic element 217, or otherwise accurately positioned to receive and transmit large amounts of data. This can allow for respective first end 238Bof fiber optic element 217 to be directly attached to photodiodes 208 and the second ends of fiber optic element 217 to be attached to corresponding microLEDs of another chip package assembly.

An outer housing 214 can be used to house fiber optic bundles 236A, 236B at or near the microLEDs 206 and photodiodes 208. Outer housings 214A, 214B may be comprised of an outer wall with a central opening 215. Outer housings 214A, 214B do not further require individual openings or mechanisms to ensure precise positioning of fiber optic elements 204 relative to microLEDs 206 and photodiodes 208. In this example, a single outer housing 214A, 214B can be used to house respective fiber optic bundle 236A, 236B where fiber optic bundle 236A connects to microLEDs 206 and fiber optic bundle 236B connects to photodiodes 208, but in other examples, more than one outer housing can be implemented.

MicroLEDs 206 in light source array 207 may serve an input/output transmission function for optical chip 234 and photodiodes 208 in sensor array 209 may serve an input/output reception function. Optical chip 234 can contain the circuitry necessary to process signals transmitted to and from microLEDs 206 and signals transmitted to and from photodiodes 208. In one example, optical chip 234 can provide instructions to a digital signal processor to convert digital signals to analog signals and to place or maintain microLEDs in an "on" state or in an "off' state. Based on the converted signal, the driver will provide power to the power terminal to turn "on" or remain "on" or turn "off" or remain "off." Each individual microLED 206 in array 207 will be "on" or "off" and emit a corresponding light signal through each fiber optic element 204. The light signal will be transmitted to a light sensor in a chip package external to chip package 230. Each photodiode 208 in array 209 will similarly receive a signal from microLEDs in a light sensor array that is external to chip assembly 230 indicating whether such microLED is in an "on" state or in an "off' state.

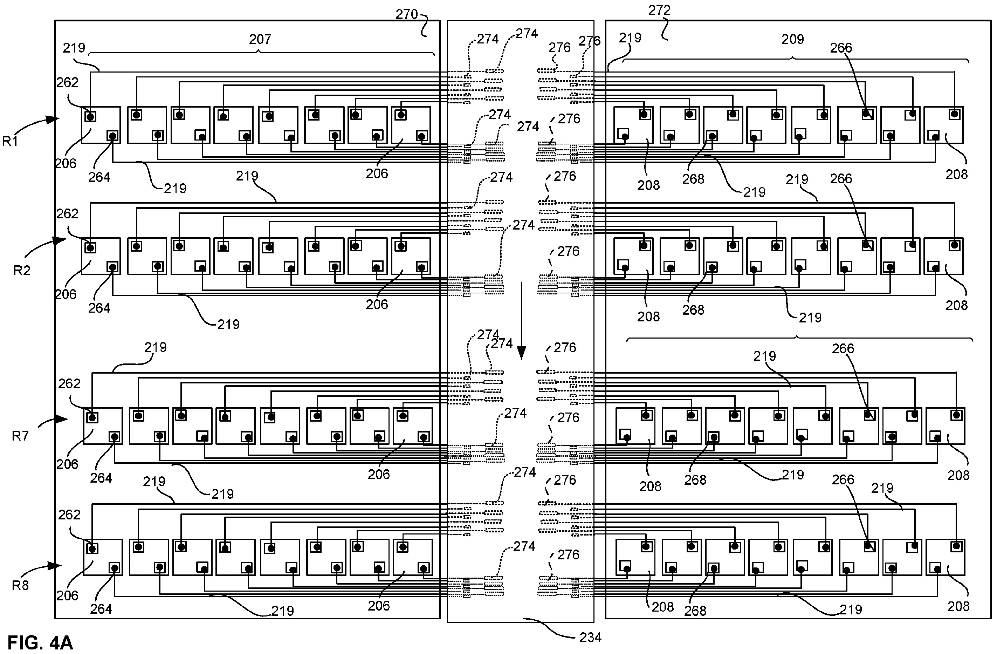

FIG. 4A is a schematic view illustrating the relationship among photodiodes, microLEDs, and optical chip 234 shown in FIG. 2. Several rows of microLEDs 206 in light source array 207 are shown, as well as several rows of photodiodes 208 in sensor array 209. Each microLED 206 in light source array 207 and each photodiode 208 in light sensor array 209 may include two terminals that are configured to power the device and act as the signal carriers. For example, each microLED 206 in light source array 207 may lie in a single ground plane and contain ground terminal 262 and power terminal 264. Ground terminals 262 and power terminals 264 of each microLED 206 may be respectively coupled or electrically connected to contacts 274 disposed at a surface of optical chip 234. In this example, traces 219 may connect ground terminals 262 and power terminals 264 to contacts 274 of chip 234. Similarly, each photodiode 208 in sensor array 209 may lie in a single ground plane and contain a ground terminal 266 and power terminal 268. Ground terminals 266 and power terminals 268 of each photodiode 208 may be further coupled or electrically connected to contacts 276 disposed at a surface of optical chip 234. In this example, traces 219 may connect ground terminals 266 and power terminals 268 to contacts 276 of chip 234. Although only first and second rows R1, R2 and seventh and eighth rows R7, R8 of array 207 are illustrated, it is to be appreciated that each row R1-R8 in this example may contain identical features, but in other examples one or more rows may differ.

MicroLED ground voltage may be a common voltage, such as 0V, which allows array 207 of microLEDs 206 to be connected together in a single ground plane 270. Similarly, photodiodes 208 in sensor array 209 may share a common ground voltage, such as 0V, such that all photodiodes in array 209 may be connected together in a single ground plane 272. In this example, microLED ground and photodiode ground are not connected to one another since their electrical characteristics are different enough to require isolating them from each other. However, in other examples, both microLEDs and photodiodes may be connected and may share a common ground.

In one example, the "on" signal and "off' signal correlate to detected voltage and nominal values assigned to voltage. The microLED ground terminals 262 and power terminals 264 may be set for two voltage levels. For example, ground terminal 262 may be set to a zero voltage in time and the power terminal 264 may be set at a nominal non-zero voltage, such as a voltage level per the microLED specifications for a particular microLED model, and can include, for example without limitation, 1V, 3V, or 5V. The voltage of a single ground terminal 262 in this example may be fixed at 0V, whereas the voltage of an individual power terminal 264 may vary over time. This modulation in time may comprise switching between a zero voltage and a nominal non-zero voltage, indicating that a digital bit being transmitted by a microLED is either a zero ("0") or a one ("1"), respectively. When the microLED is in an "on" state, power terminal 264 will have a current nominal non-zero voltage and the digital bit is a one ("1"). When the microLED is in an "off' state, power terminal 264 will have a current voltage that is below the nominal non-zero voltage (*e.g.,* 0V) and the digital bit is a zero ("0"). In some instances, the ground voltage may instead indicate a one ("1") and the nominal voltage may indicate a zero ("0"). In still other examples, different numbers can be assigned altogether.

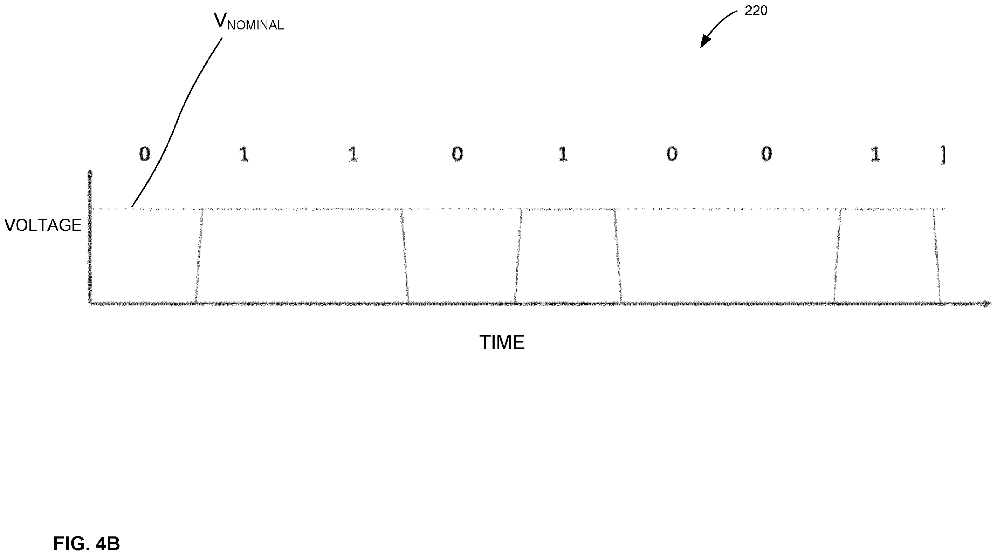

FIG. 4B shows an example voltage variation graph 220 that illustrates voltage variation for an individual microLED 206 as a function of time based on the received digital signal, but that can be implemented for all microLEDs in a light source array. This example graph illustrates 8 bits of a digital signal, but other numbers of bits of digital signal can be implemented. The nominal non-zero voltage may be selected based on the microLED specification and, as previously discussed, need not be precisely controlled for a particular level of light output. The nominal non-zero voltage can be selected at the voltage that will determine whether the microLED is considered to be "on" or in an "on" state. Since the desired light output signal is detected as being either "on" or "off," the voltage may be regulated between two levels, such as zero and the nominal non-zero values shown.

Once the driver provides power to the power terminal of the microLEDs according to the received signal from the digital-to-analog converter, microLEDs will then be in either the "on" state and emitting light or in the "off" state and not emitting light. The light will then emanate through first ends 238 of fiber optic elements 204 which are connected to microLEDs 206. Fiber optic elements 204 will transmit a signal to photodiodes of a chip package external to package 230.

Photodiodes 208 in sensor array 209 are coupled to external microLEDs of a chip package assembly external to chip package 230. Photodiodes 208 can sense the received optical signal through fiber optic elements 217. Photodiodes 208 may also be provided with two voltage levels such as zero and nominal non-zero, and the amount of current is sensed to determine if light is being received at the photodiode. Depending on whether the external microLED of another chip package assembly is in an "on" state or in an "off" state, photodiode 208 can receive a signal, which in this example can be assigned either "0" or "1." In other examples, other numbers can be utilized. Photodiodes do not require a wide variation of different levels of current. The only required determination is whether the current is above or below a certain threshold to determine if the signal being received is a "0" or "1."

Once photodiode 208 receives the unmodulated optical light signal, the photodiode outputs an electrical signal. Photodiodes 208 can transmit the electrical signal to a digital processor or the like to convert the electrical signal to a digital signal and determine whether the signal is a "1" and the external microLED is "on" or whether the signal is a "0" and the external microLED is "off." Each photodiode 208 in the light sensor array 209 can receive a single signal from a paired external microLED. As such, the electrical signal output by each photodiode 208 may differ. For example, some of the external microLEDs may be "on," while others are "off' at any given point in time. Further, each photodiode 208 in sensor array 209 may then transmit the electrical signal to another component within the same or different package. For example, photodiodes 208 may transmit the signal to an analog-to-digital converter, which may convert the electrical signal to a digital signal. The analog-to-digital converter may be part of a digital signal processing (DSP) chip. The DSP chip may transmit the digital signal to different chips or other components in the same chip package or another chip package, such as power chips, microprocessors, memory chips, and processor chips.

Among others, according to aspects of the disclosure, optical systems or interconnects can be incorporated into a chip package assembly and can provide an optical interconnection between chip package assembly 230 and one or more external chip packages having light sources and light sensors. With a multiplicity of microLED 206 and photodiode 208 pairs in the respective light source and sensor arrays, each microLED 206 and photodiode 208 pair in the respective light source and sensor arrays may be independent of one another. Data may be transmitted to microLEDs 206 from different chips and/or devices in communication with the individual microLEDs 206, which is then transmitted to external photodiodes. External photodiodes will transmit the unmodulated signal to the analog-to-digital converter and the DSP chip can communicate with other devices. For example, one or more microLEDs 206 may be conductively connected and communicate with a first memory chip while one or more other microLEDs 206 in light source array 207 may be electrically connected and communicate with a second memory chip. Each external photodiode paired with a microLED 206 communicating with a first memory chip may, in turn, transmit signals and communicate with a first processor. Each external photodiode that is paired with a microLED 206 that communicates with a second memory chip may, in turn, transmit signals to the analog-to-digital converter and the digital processor can further communicate with a second processor. Thus, at any given point in time, different components within a chip package assembly may be communicating with another component, such as other chips in the same or another package, through the optical interconnection system.

This overall configuration can obviate the need to modulate specific characteristics of the light signal, such as frequency and bandwidth of the light signal transmitted by each of the microLEDs 206 or received by photodiodes 208. In particular, there is no need to modulate specific characteristics of the light signal transmitted by microLEDs 206 in chip package 230 to external photodiodes, or the characteristics of light received by photodiodes 208 in chip package 230 received from external microLEDs of another chip package. Data regarding frequency, bandwidth, and other characteristics of the light does not need to be detected or modulated by photodiodes. Rather, data transmitted by the multiplicity of microLEDs 206 and through fiber optic elements 204 concerns whether light emanating from each microLED is "on" or "off." Similarly, data transmitted by similarly configured external microLEDs and through fiber optic element 217 concern whether light emanating or emitting from each external microLED is "on" or "off." As a result, each fiber optic element 204 can be directly attached to each microLED 206 and an external photodiode without the need for the fiber optic elements 204 to be precisely aligned with each microLED 206 and/or external photodiode because it is not necessary to ensure that the highest quality light and increased data is transmitted through each fiber optic element.

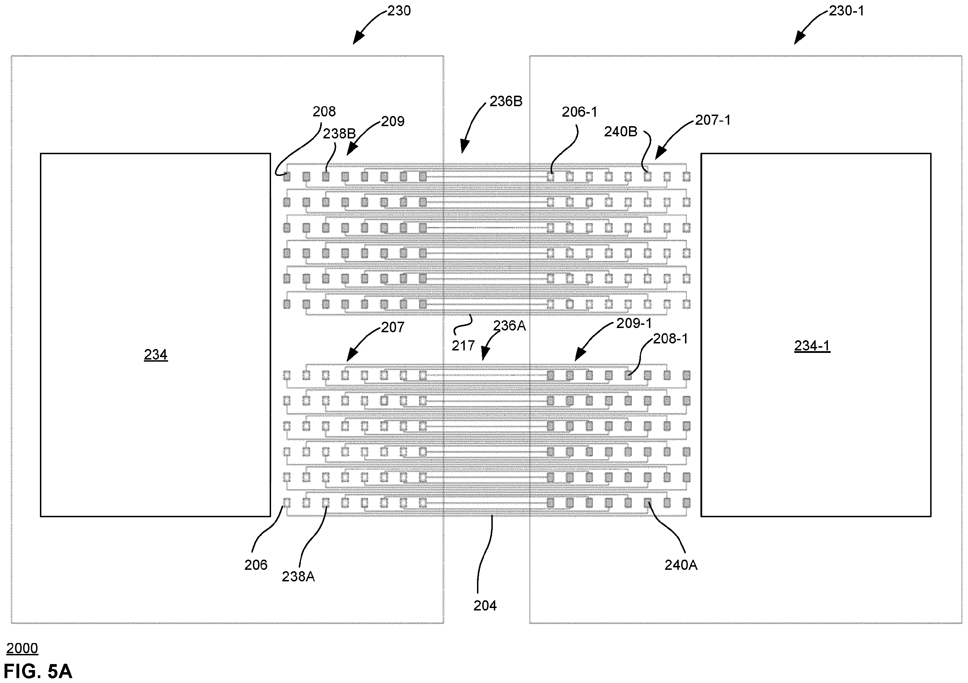

FIGS. 5A-5C are schematic diagrams providing example optic systems for interconnecting one or more chip package assemblies, in which each of the chip package assemblies have an optical interconnect system that includes multiple light sources and light sensors that are configured to communicate with respective light sensors and light sources of another chip package assembly in the system. With reference first to FIG. 5A, system 2000 includes package 230, which in this example is also a first chip package 230, and a second chip package 230-1, which are optically interconnected to one another. First chip package 230 is chip package 230 previously described herein, and second chip package 230-1 in this example may also be identical to chip package 230. In other examples, the chip packages may differ and/or include additional components. Each chip package 230, 230-1 respectively includes an IC chip 234, 234-1, light source array 207, 207-1, including a plurality of microLEDs 206, 206-1, and a light sensor array 209, 209-1 having a plurality of light sensors, such as photodiodes 208, 208-1. First fiber optic bundle 236A includes a plurality of individual fiber optic elements 204 that extend from microLEDs 206 of chip package 230 to photodiodes 208-1 of second chip package 230-1. As shown, each of the fiber optic elements 204 in first bundle 236A have first ends 238A attached to microLEDs 206 of first chip package 230 and the second ends 240A are attached to photodiodes 208-1 of second chip package 230-1. Similarly, each of the fiber optic elements 217 in second bundle 236B have first ends 238B attached to photodiodes 208 of first chip package 230 and second ends 240B attached to light sources or microLEDs 206-1 of second chip package 230-1.

As discussed with regard to the prior embodiments, fiber optic elements 204 of first fiber optic bundle 236A and second fiber optic elements 217 of second fiber optic bundle 236B will each carry a signal indicating whether the microLED to which it is attached is in an "on" state or in an "off' state. For example, fiber optic bundle 204 will carry a signal transmitted by microLEDs 206 in light source array 207 of chip package assembly 230 to photodiodes 208-1 of light sensor array 209-1 of second chip package assembly 230-1. Similarly, fiber optic bundle 217 will carry a signal transmitted by microLEDs 206-1 of second chip package 230-1 to photodiodes 208 of first chip package assembly 230. The optical interconnect systems of each chip package allow for optical interconnection between first and second chip packages 230, 230-1 in system 2000.

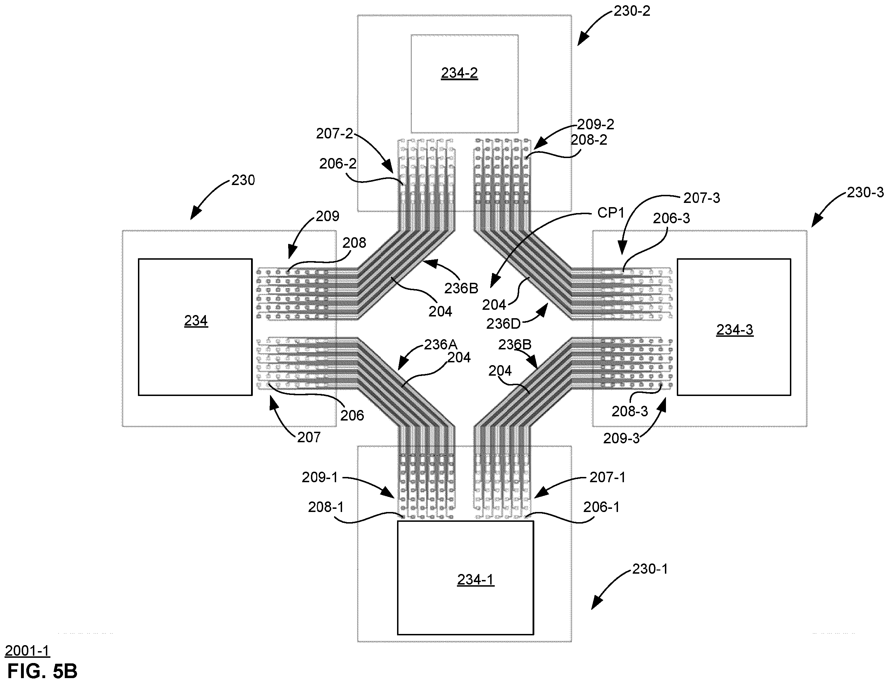

Optical interconnects allow for the optical interconnection of a chip package assembly to one or more chip package assemblies. The prior examples describe systems where one chip package assembly is optically interconnected to one other chip package assembly. FIG. 5B illustrates an example where one chip package assembly is optically interconnected to at least two other chip package assemblies. In this example, system 2000-1 includes four chip package assemblies: first chip package assembly 230, second chip package assembly 230-1, third chip package assembly 230-2, and fourth chip package assembly 230-3 (collectively "chip package assemblies 230, 230-1, 230-2, 230-3"). Each of the chip package assemblies 230, 230-1, 230-2, 230-3 may be structurally identical to chip package assembly 230 previously described herein and the details and components of each chip package assembly are not fully discussed for ease of discussion and to focus the discussion on the optical interconnection of the four chip package assemblies. Each chip package assembly 230, 230-1, 230-2, 230-3 of system 2000-1 respectively includes: IC chip 234, 234-1, 234-2, 234-3; light source array 207, 207-1, 207-2, 207-3 that includes respective microLEDs 206, 206-1, 206-2, 206-3; sensor array 209, 209-1, 209-2, 209-3 that includes multiple sensors, such as respective photodiodes 208, 208-1, 208-2, 208-3. The chip package assemblies 230, 230-1, 230-2, 230-3 are spaced apart from one another and extend around central portion CP1. First chip package assembly 230 is positioned across from fourth chip package assembly 230-3. Second chip package assembly 230-1 is positioned across from third chip package assembly 230-2. Each of the chip package assemblies 230, 230-1, 230-2, 230-3 are positioned so that the respective light source arrays 207, 207-1, 207-2, 207-3 and respective microLEDs 206, 206-1, 206-2, 206-3 and the respective light sensor arrays 209, 209-1, 209-2, 209-3, which in this example include respective photodiodes 208, 208-1, 208-2, 208-3 are positioned facing one another and towards central portion CP1.

Fiber optic bundles couple and optically interconnect one of the chip package assemblies 230, 230-1, 230-2, 230-3 to another of the chip package assemblies 230, 230-1, 230-2, 230-3. In this example, first fiber optic bundle 236A includes multiple fiber optic elements 204; second fiber optic bundle 236B includes multiple fiber optic elements 217; third fiber optic bundle 236C includes multiple fiber optic elements 204 and fourth fiber optic bundle 236D includes multiple fiber optic elements 204.

As shown, first fiber optic bundle 236A includes fiber optic elements 204 that interconnect each microLED 206 of first chip package assembly 230 to photodiodes 208-1 of second chip package assembly 230-1. Second fiber optic bundle 236B includes fiber optic elements 217 that interconnect each photodiode 208 of first chip package assembly 230-1 to microLEDs 206-2 of third chip package assembly 230-2. Third fiber optic bundle 236C includes fiber optic elements 204 that interconnect each microLED 206-1 in second chip package assembly 230-1 to photodiodes 208-3 of fourth chip package assembly 230-3. Fourth fiber optic bundle 236D optically interconnects photodiodes 208-2 of third chip package assembly 230-2 to microLEDs 206-3 of fourth chip package assembly 230-3.

As in the previous examples, each of the microLEDs 206, 206-1, 206-2, 206-3 in the respective light sensor arrays 207, 207-1, 207-2, 207-3 of system 2000-1 will transmit an "on" signal or "off' signal to one of the respective photodiodes 208, 208-1, 208-2, 208-3 in the respective light sensor arrays 209, 209-1, 209-2, 209-3 to which it is connected. As in the previous examples, photodiodes 208, 208-1, 208-2, 208-3 can sense the received optical signal through the respective fiber optic elements 204 of fiber optic bundles 236A, 236B, 236C, 236D.

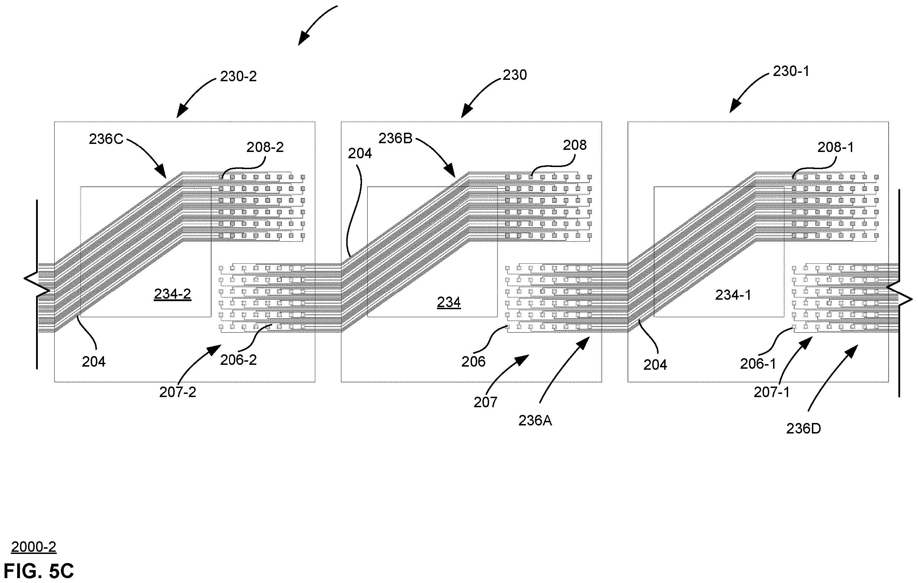

FIG. 5C illustrates another example system 2000-2 where three chip package assemblies are shown optically interconnected and capable of being interconnected with additional chip package assemblies. Example system 2000-2 may include first chip package assembly 230, second chip package assembly 230-1, and third chip package assembly 230-2. The first, second, and third chip package assemblies or chip packages 230, 230-1, 230-2 may be identical to the chip packages 230 previously disclosed herein with regard to FIGS. 2-4B and are not described in more detail to focus the discussion on the optical interconnection between first, second, and third chip packages 230, 230-1, 230-2.

In this example, first, second, and third chip packages 230, 230-1, 230-2 are arranged directly adjacent one another in a single line. Second chip package 230-1 is positioned adjacent a first outer edge of first chip package 230 and third chip package 230-2 is positioned adjacent a second outer edge of first chip package 230. In this configuration, third and fourth outer edges of each of the first, second, and third chip packages 230, 230-1, 230-2 are shown generally aligned with one another and along a same plane. In other examples, they may not be aligned with one another and/or may extend along different planes.

As in the previous examples, the first, second, and third chip package assemblies 230, 230-1, 230-2 of system 2000-2 respectively include: IC chips 234, 234-1, 234-2; light source arrays 207, 207-1, 207-2 that includes respective microLEDs 206, 206-1, 206-2; sensor arrays 209, 209-1, 209-2 that includes multiple sensors, such as respective photodiodes 208, 208-1, 208-2. A first fiber optic bundle 236A includes fiber optic elements 204 that connect microLEDs 206 of first chip package 230 to photodiodes 208-1 of second chip package 230-1. Second fiber optic bundle 236B includes fiber optic elements 217 that connect each photodiode 208 of first chip package 230 to microLEDs 206-2 of third chip package 230-2.

Unlike previous examples, fiber optic elements 204 of first, second, and third fiber optic bundles 236, 236A, 236B of system 2000-2 will extend over or across one or more of IC chips 234, 234-1, 234-2 of the first, second, and third chip package assemblies 230, 230-1, 230-2, 230-3 of system 2000-2. For example, fiber optic elements 204 of first fiber optic bundle 23 6A extends over or across at least a portion of IC chip 234-1; fiber optic elements 204 of second fiber optic bundle 236B extend over or across at least a portion of IC chip 234-1; and fiber optic elements 204 of third fiber optic bundle 236C extend over or across at least a portion of IC chip 234-2.

In this example, only three chip packages are shown coupled together. However, third chip package 230-2 is configured to couple to a fourth chip package (not shown) and second chip package 230-1 is configured to couple to a fifth chip package (not shown), such that there are five chip packages in the system. For example, fiber optic elements 204 of third fiber optic bundle 236C have a first end attached to photodiodes 208-2 of third package 230-2 and a second end (not shown) that can attach to microLEDs of an external chip package assembly. Similarly, fiber optic elements 204 of fourth fiber optic bundle 236D have a first end attached to microLEDs 206-1 of second chip package assembly 230-1 and a second end (not shown) that is configured to attach to photodiodes of a fifth chip package assembly (not shown).

In each of the previous examples, each of the chip package assemblies are shown on the same plane. However, it is to be appreciated that one or more of the chip package assemblies may be positioned on a different plane or a parallel plane. In such configuration one or more of the chip packages may be vertically stacked on top of one another or offset from one another.

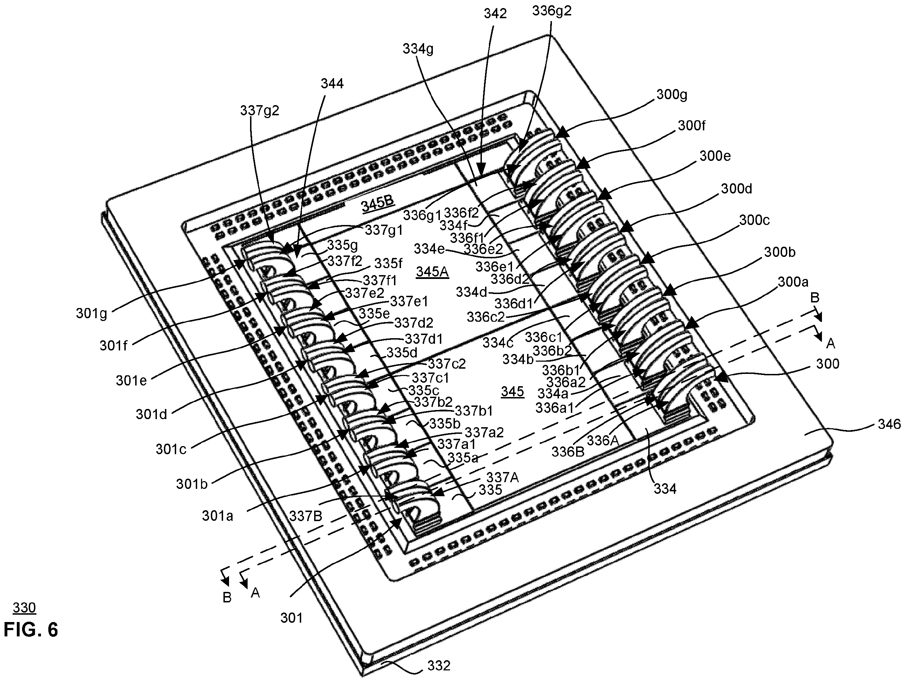

FIG. 6 illustrates a schematic view of another chip package assembly 330 that implements multiple optical interconnect arrays. Package assembly 330 includes a substrate 332, high-performance chips 345, 345A, 345B, and a plurality of optical interconnect systems or optical interconnects 300, 300a, 300b, 300c, 300d, 300e, 300f, 300g (collectively "optical interconnects 300-300g"), 301, 301a, 301b, 301c, 301d, 301e, 301f, 301g (collectively "optical interconnects 301-301g"). Each of the plurality of optical interconnects 300-300g, 301-301g can further include at least an array of photodiodes, an array of light sources, and fiber optic bundles 336A, 336B, 336a1, 336a2, 336b1, 336b2, 336c1, 336c2, 336d1, 336d2, 336e1, 336e2, 336f1, 336f2, 336g1, 336g2, (collectively "fiber optic bundles 336A-336g"), 337A, 337B, 337a1, 337a2, 337b1, 337b2, 337c1, 337c2, 337d1, 337d2, 337e1, 337e2, 337f1, 337f2, 337g1, 337g2 (collectively "fiber optic bundles 337A-337g"). Fiber optic bundles 336A-336g are joined to IC chips or optical chips 334, 334a, 334b, 334c, 334d, 334e, 334f, 334g (collectively "optical chips 334-334g") and fiber optic bundles 337-337g are joined to optical chips 335, 335a, 335b, 335c, 335d, 335e, 335f, 335g (collectively "optical chips 335-335g"). In this example, each of the optical interconnects 300-300g and 301-301g are structurally the same, but in other examples they may differ.

A first set 342 of optical chips may be arranged on one side of package assembly 330 and may include chips 334-334g. A second set 344 of optical chips may include chips 335-335g. Second set 344 may be spaced apart from first set 342 and arranged on an opposite side of package assembly 330. In addition to first and second sets 342,344 of optical chips, additional chips may be implemented within the package assembly 330 to perform the same and/or additional functions. In this example, without limitation, one or more chips may be a processing unit. For example, one or both integrated circuit chips 345, 345A may be a central processing unit ("CPU"), graphics processing unit ("GPU"), field programmable gate arrays ("FPGA") or application-specific integrated circuits ("ASIC"), such as a tensor processing unit ("TPU"). In some examples, the integrated circuit chips 345, 345A may be configured for efficient execution of certain types of operations, e.g., operations for accelerating machine learning model inference or training. Example operations include matrix-matrix multiplication, matrix-vector multiplication, quantization, and/or other operations for processing a machine learning model, such as a neural network. Additional chips, such as a serializer/deserializer chip 345B may also be included, but any number and type of chips may be implemented within assembly 330. A stiffener 346 may extend around a periphery of package assembly 330 and be positioned adjacent the first and second sets 342, 344 of optical chips.

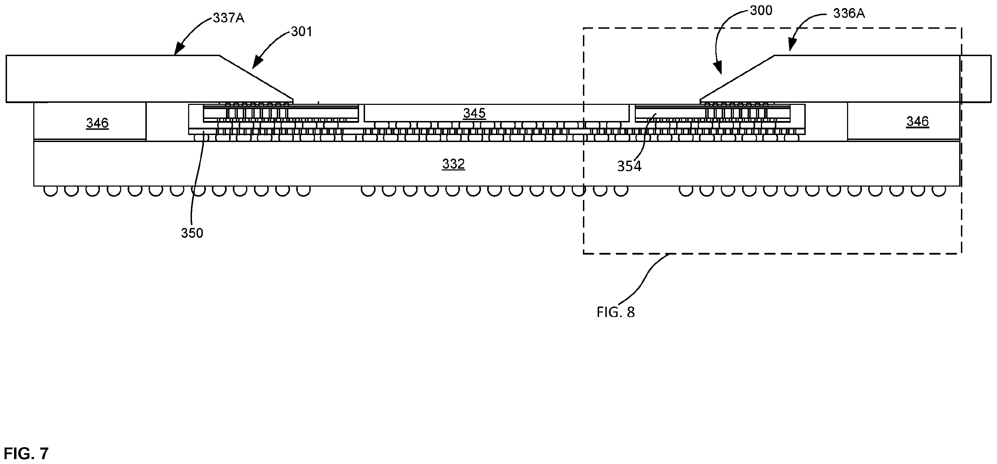

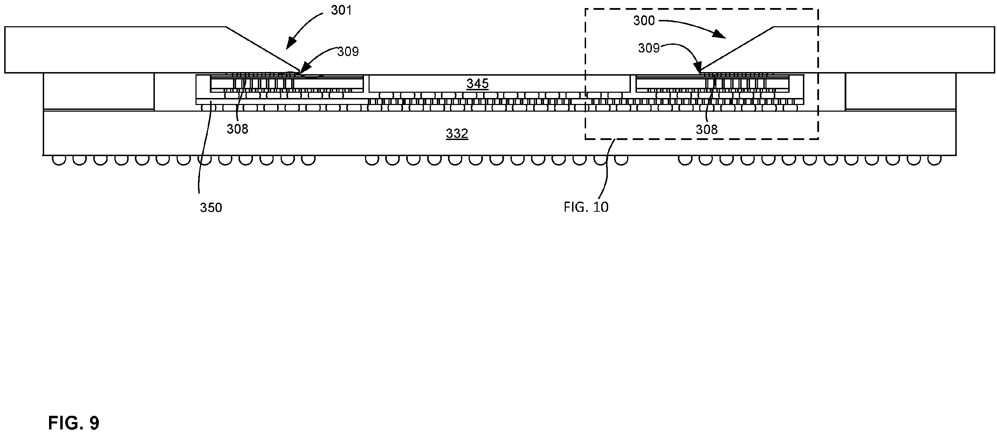

Fiber optic bundles 336A-336g may be attached to respective optical chips 334-334g and fiber optic bundles 337A-337g may be attached to respective optical chips 335-335g. FIGS. 7-8 better illustrate one example arrangement of optical interconnects 300, 301 within chip package assembly 330 and relative to other components in package assembly 330. MicroLEDs 306 and optional microlenses 305 of optical interconnects 300 will be seen in these figures, whereas photodiodes of optical interconnects 300, 301 are not visible in these cross-sectional views and will be further described in FIGS. 9-10.

With reference first to FIG. 7, a cross-sectional view of FIG. 6 taken across line A-A, substrate 332 extends across a length of assembly 330. Stiffener 346 overlies substrate 332 and is positioned at outermost ends of assembly 330. Optical interconnects 300, 301 and chip 345 overlie substrate 332 and are conductively connected to substrate 332 through package interposer 350. Package interposer 350 may be a silicon wafer with through silicon vias 352. Package interposer 350 can provide for further interconnection between optical chips 335, 334 and central chip 345, as well as other components within package 330. Fiber optic bundles 336A, 336B, 337A, 337B can overlie stiffener 346.

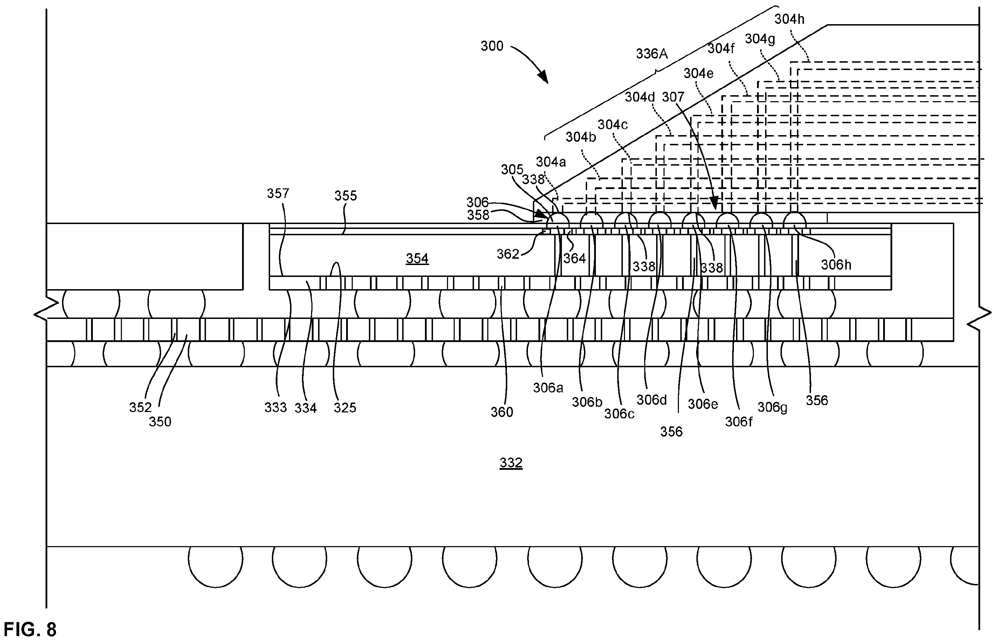

FIG. 8, an enlarged area of FIG. 7, further illustrates structural components of optical interconnect 300, including array 307 of light sources, such as microLEDs 306a, 306b, 306c, 306d, 306e, 306f, 306g, 306h (collectively "microLEDs 306a-306h" or "microLEDs 306"), optional microlenses 305, carrier wafer or optical interposer 354, optical chip 334, and fiber optic bundle 336A, which includes individual fiber optic elements 304a, 304b, 304c, 304d, 304e, 304f, 304g, 304h. In this example, light source array 307 includes a first row of microLEDs, which in this case includes eight microLEDs 306a-306h. As previously discussed, array 307 will include a multiplicity of microLEDs that may include numerous microLEDs. In one example, microLEDs may include 10 or more microLEDs, 100 or more microLEDs, or a number of microLEDs in the hundreds, thousands, or more. It follows that the number of corresponding signal paths may be greater than 10, greater than 100, or even greater than 1000. In other examples, the number of microLEDs may be less than 100. As shown, only eight microLEDs 306a-306h are visible in this view for ease of illustration and discussion, but it is to be understood that array 307 will include numerous other microLEDs that do not appear in this cross-sectional view.

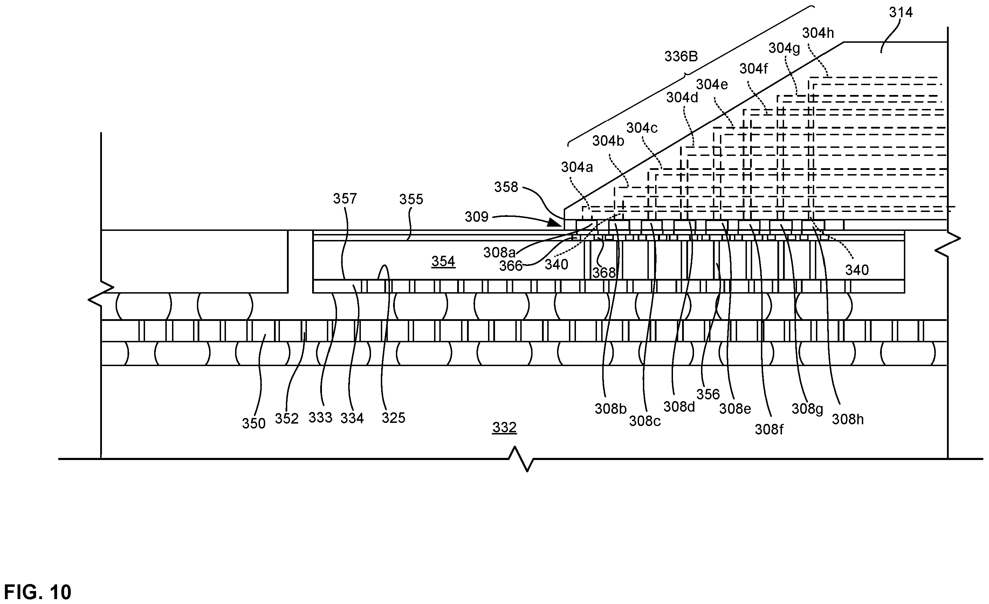

Optical chip 334 includes active front surface 333, an opposed rear surface 325 and vias 360 extending at least partially through optical chip 334. In this example, microLEDs 306 overlie rear surface 325 of optical chip 334 and are conductively connected to optical chip 334 through optical interposer 354. Optical interposer 354, in this example, may be a silicon carrier wafer with through silicon vias 356 extending through outermost surfaces of optical interposer 354, but other types of carriers capable of supporting microLEDs 306a-306h and conductively connecting them to optical chip 334 may be implemented. Each microLED 306a-306h may include a ground contact or terminal 362 and power contact or terminal 364. As shown, optical chip 334 may be electrically connected to substrate 332 through package interposer 350, as well as electrically connected to microLEDs 306a-306h and photodiodes 308a-308h (FIG. 10) through optical interposer 354. First end 338 of fiber optic element 304a of fiber optic bundle 336A may be directly attached to microLED 306a, which in this example includes microlenses 305. Known means can be used to attach first end 338 of fiber optic element 304a to microLED 306a, such as an optically clear adhesive 358. Similarly, each fiber optic element 304b-304h in fiber optic bundle 336A may have its respective first end 338 coupled to microLEDs 306b-306h using known means. In one example, first ends 339 are directly attached to microLEDs, such as using an optically clear adhesive 358. In other examples, as will be described herein, fiber optic bundle 336A may be positioned within a housing that can be removably attached to microLEDs 306 in the array. For example, as will be discussed herein, microLEDs within a housing may additionally or alternatively be clipped to chip package 330.

In this cross section, fiber optic elements 304a, 304b, 304c, 304d, 304e, 304f, 304g, 304h of fiber optic bundle 336A are seen. A single fiber optic element 304 in fiber optic bundle 336BAcan be used to connect a single microLED 306 in light source array 307 to a photodiode in a sensor array external to chip package 330, such that microLED 306 and the photodiode of an external chip package are in communication with one another through fiber optic elements 304 of fiber optic bundle 336A. For example, first end 338 of fiber optic element 304a of fiber optic bundle 336B can directly connect to a first microLED 306a (FIG. 8) and a second end (not shown) of fiber optic element 304a can directly connect to an external photodiode of another chip package, such that there is a one-to-one correspondence between each microLED 306 and each photodiode in the external package.

FIGS. 9-10 illustrate an example arrangement of a row of photodiodes of sensor array 309 of optical interconnect 300 within package assembly 330. FIG. 9 shows array 309 of photodiodes 308 in a cross-sectional view of package assembly 330 taken through line B-B (FIG. 6) and FIG. 10 shows an enlarged area of FIG. 9 best illustrating photodiodes 308. Since photodiodes 308 are positioned adjacent microLEDs 306 and at a surface of optical chip 334, FIGS. 9 and 10 are otherwise similar to FIGS. 7-8, except that in place of microLEDs 306 and microLED lenses 305, photodiodes 308 of sensor array 309 are illustrated in this cross-section.

FIG. 9 illustrates the general arrangement of sensors, such as photodiodes 308 of optical systems or interconnects 300, 301 and fiber optic bundle 336B (FIG. 10) within package assembly 330. As seen in FIG. 10, a row of photodiodes 308 (308a, 308b, 308c, 308d, 308e, 308f, 308g, and 308h, collectively "photodiodes 308a-308h" or "photodiodes 308") of sensor array 309 are visible, but as previously discussed, sensor array 309 will include a multiplicity of photodiodes 308 and be arranged in additional rows of photodiodes, such that the total number of photodiodes can number into the hundreds, thousands, or even more. The number of photodiodes 308 in sensor array 309 can correspond to the number of light sources, which in this example are microLEDs of a light source array of an external chip package assembly. Sensor array 309 overlies an inactive and rear surface 325 of optical chip 334, which in this configuration, is the same optical chip 334 that microLEDs 306 (FIG. 8) overlie. In other examples, photodiodes 308 may be positioned at a surface of a directly adjacent chip, facing an active surface of optical chip 334, or at a surface of substrate 332. Active front surface 333 of optical chip 334 faces toward package interposer 350 and may be conductively connected to package interposer 350 through conductive vias 352 in package interposer 350 and solder balls. Each photodiode 308a-308h can include a respective ground terminal 366 and power terminal 368.

Photodiodes 308 may be conductively connected to optical chip 334 through conductive vias 356 extending through top surface 355 and bottom surface 357 of optical interposer 354. Photodiodes 308 may also be connected to microLEDs of an external chip package through fiber optic elements in bundle 336B. A single fiber optic element 304 in fiber optic bundle 336B can be used to connect a single photodiode 308 in light sensor array 309 to a microLED in a light source array external to chip package 330. As shown, first end 340 of each fiber optic element 304 of bundle 336B can be coupled to photodiodes 308 using any means. In one example, each fiber optic element 304 is directly attached to photodiodes 308, and in some examples, an optically clear adhesive 358 can be utilized. This configuration allows for photodiodes 308 of chip package 330 and the microLED of an external chip package to be in communication with one another through fiber optic elements 304 of fiber optic bundle 336B. For example, first end 338 of fiber optic element 304a of fiber optic bundle 336B can directly connect to a first microLED 306a (FIG. 8) and a second end (not shown) of fiber optic element 304a can directly connect to an external photodiode of another chip package, such that there is a one-to-one correspondence between each microLED 306 and each photodiode in the external package. As noted above, in this example, photodiodes 308 of chip package 330 are not directly connected to microLEDs 306. Fiber optic bundle 336A instead includes a plurality of single fiber optic elements 304 that will each join each microLED 306 in light source array 307 to a corresponding single photodiode in a sensor array of another chip package external to chip package 330.

In this example configuration, outer housing 314 can be used to house or support fiber optic elements 304a-304h in fiber optic bundle 336A within package assembly 330. Since the only signal that each fiber optic element 304a-304h needs to carry or transmit is whether the microLED to which each corresponding fiber optic element 304a-304h is attached is in an "on" state or in an "off' state, each end of fiber optic element 304a-304h can be directly attached to respective microLEDs 306a-306h. Housing 314 does not need to be configured to orient fiber optic elements 304a-304h at certain angles or to precisely align fiber optic elements 304a-304h, or otherwise position fiber optic elements 304a-304h to receive large amounts of data.

When chip package assembly 330 is in use, an optical interconnect system can provide an improved optical interconnection to a corresponding optical interconnect system of another chip package. The optical interconnect system of chip package assembly 330 can include at least microLEDs 306 in light source array 307 and photodiodes 308 in sensor array 309. For example, microLED 306a in the light source array 307 can be turned "on" or remain "on" and emanate light or turned "off" or remain "off' and not emanate light or emanate light below a predetermined amount. Fiber optic element 304a, which is attached at one end to microLED 306a, transmits a corresponding light signal or unmodulated light signal indicating whether microLED 306a is in an "on" state or in an "off" state to a photodiode of another chip package external to the chip package assembly 330. While microLEDs transmit signals external to chip package 330, photodiodes 308a-308h (and all other photodiodes) within chip package 330 receive incoming signals from corresponding microLEDs of a light source array of an external chip package. Photodiode 308a of chip package 330 receives the unmodulated light signal through fiber optic element 304a of fiber optic bundle 336B and detects whether the light signal indicates that external microLED is in an "on" state or in an "off" state. Photodiode 308a may convert the unmodulated light signal into an electrical signal, after which an analog-to-digital converter can convert the signal to a digital signal. The digital signal may then be transmitted to other components within or outside of the package. The process of transmitting signals external to chip package 330, as well as receiving signals from external chip packages, may occur for the multiplicity of microLEDs in light source array 307, which includes microLEDs 306a-306h and photodiodes in sensor array 309, which includes sensors 308a-308h. The timing may be the same or different, such that some of the microLEDs in chip package assembly 330 and microLEDs in a chip package assembly external to chip package assembly 330 may be in an "on" state at any given point in time, while other microLEDs may be in an "off" state at any given point in time.

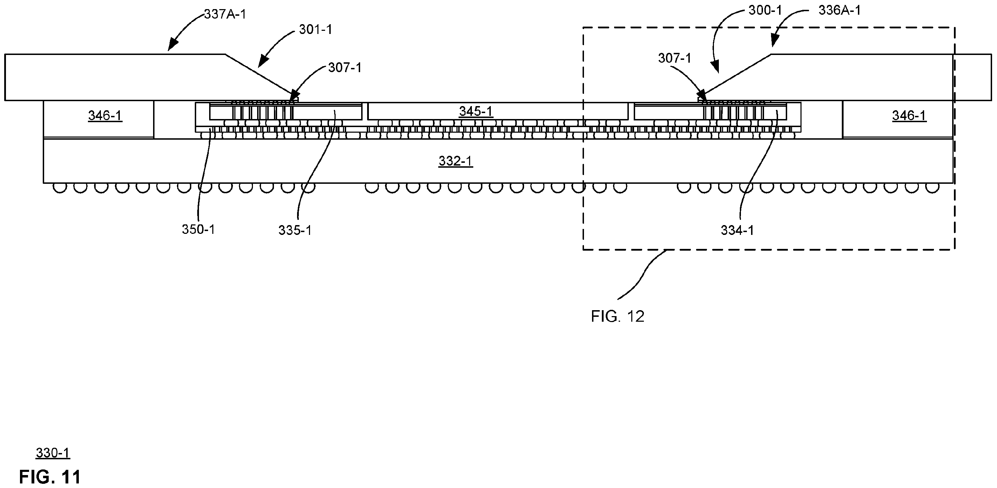

FIG. 11 provides an alternative chip package assembly 330-1 taken along line A-A of chip package assembly 330 shown in FIG. 6. Assembly 330-1 can include the same components as assembly 330, differing only in the orientation of chips 334-1, 335-1 in the face-up position and the absence of an optical interposer, as present in chip package assembly 330 of FIG. 7. For ease of discussion, only the cross-section taken along line A-A will be discussed to illustrate this distinction, but it is to be appreciated that chip package assembly 330-1 can otherwise be similar to chip package assembly 330 of FIG. 6 and similar reference numerals will be used to identify similar structural features, which are not fully discussed herein for brevity of the discussion.

Package assembly 330-1 includes substrate 332-1, high-performance chip 345-1, a package interposer 350-1 and a plurality of optical interconnect systems or interconnects 300-1 and 301-1. Substrate 332-1 extends across a length of assembly 330-1 and supports components in assembly 330-1. Each of the plurality of optical interconnects 300-1, 301-1 can further include at least an array of photodiodes, which are not seen in this view, an array 307-1 of microLEDs, and fiber optic bundles 336A-1 and 337A-1. Optical interconnect system or interconnects 300-1 and 301-1 and high-performance chip 345-1 overlie substrate 332-1 and are electrically connected to substrate 332-1. Fiber optic bundle 336A-1 may be joined to optical chip 334-1 and fiber optic bundle 337A-1 may be joined to optical chip 335-1. Stiffener 346-1 overlies substrate 332-1 and is positioned at outermost ends of assembly 330-1. Fiber optic bundles 336A-1 and 337A-1 can further overlie stiffener 346-1, chips 334-1, 335-1, and package interposer 350-1 so as to provide an interconnection between substrate 332-1 and the components that are electrically connected to substrate 332-1.

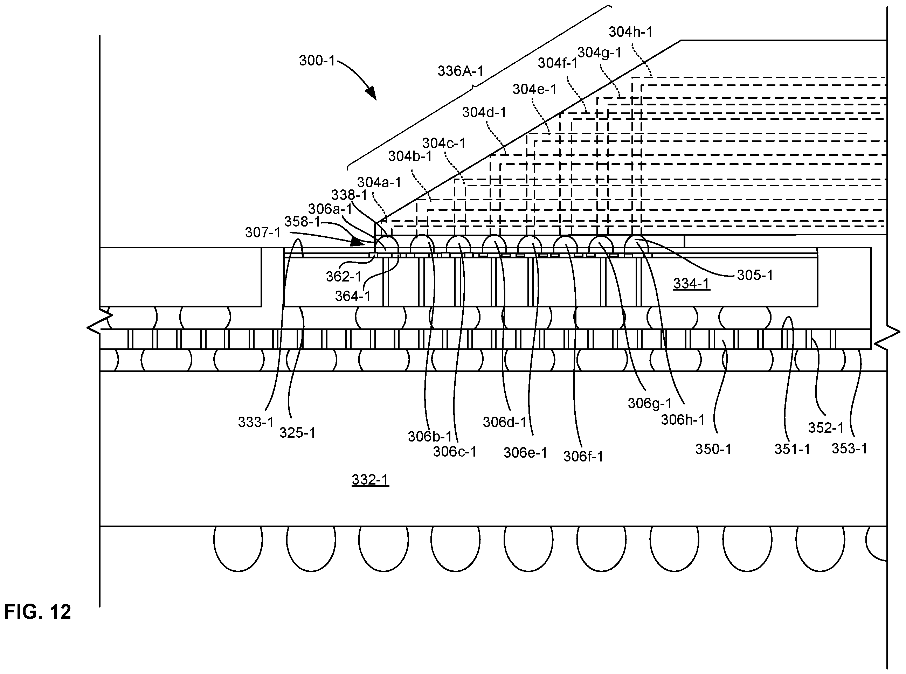

With reference to FIG. 12, an enlarged view of a portion of FIG. 11 is shown. Structural components of optical interconnect system 300-1 are better illustrated, including at least array 307-1 of light sources, such as microLEDs 306a-1, 306b-1, 306c-1, 306d-1, 306e-1, 306f-1, 306g-1, 306h-1 (collectively "microLEDs 306a-1 through 306h-1" or "microLEDs 306-1") and optional microlenses 305-1, optical chip 334-1, and fiber optic bundle 336A-1, which includes individual fiber optic elements 304a-1, 304b-1, 304c-1, 304d-1, 304e-1, 304f-1, 304g-1, 304h-1.

Chip package assembly 330-1 differs from the prior example due to the orientation of optical chip 334-1. As shown, optical chip 334-1 is positioned in a face-up position with its active surface 333-1 facing away from substrate 332-1 and toward microLEDs 306-1 and with its rear and passive surface 325-1 facing towards substrate 332-1. Additional metallization layers 339-1, 341-1 may also be provided at active surface 333-1 of optical chip 334-1. Optical chip 334-1 may be conductively connected to substrate 332-1 and other components in package assembly 330-1 through package interposer 350-1. As in the prior example, package interposer 350-1 may further include conductive vias 352-1 that extend between top surface 351-1 and bottom surface 353-1 of package interposer 350-1.

MicroLEDs 306a-1 through 306h-1 may be disposed at active surface 333-1 of optical chip 334-1. MicroLEDs 306a-1 through 306h-1 may each further include a ground terminal 362-1 and a power terminal 364-1. As in the prior examples, first ends 338-1 of fiber optic elements 304a-1 through 304h-1 may be connected to respective microLEDs 306a-1 through 306h-1. As shown, fiber optic elements 304a-1 through 304h-1 can be directly attached to microLEDs 306a-1 through 306h-1 using any known means, such as an adhesive 358-1 that is optically transparent. In this example, array 307-1 includes a first row of microLEDs, which in this case includes eight microLEDs 306a-1 through 301h-1. As previously discussed, array 307-1 will include a multiplicity of microLEDs that may include 100 or more microLEDs, or that may number in the tens, hundreds, thousands, or more. The number of corresponding signal paths may be greater than 10, greater than 100 or even greater than 1000. Only eight microLEDs, 306a-1 through 306h-1, are visible in this view for ease of illustration and discussion, but it is to be understood that array 307-1 will include numerous other microLEDs that do not appear in this cross-sectional view. In other examples, photodiodes 308a-1 through 308h-1 may be positioned at a surface of a directly adjacent chip, face a rear surface of optical chip 334-1, or be positioned at a surface of substrate 332-1 or another surface. The second ends of fiber optic elements 304a-1 through 304h-1 may be connected to photodiodes of a light sensor array of an external chip package, which are not shown in this example.

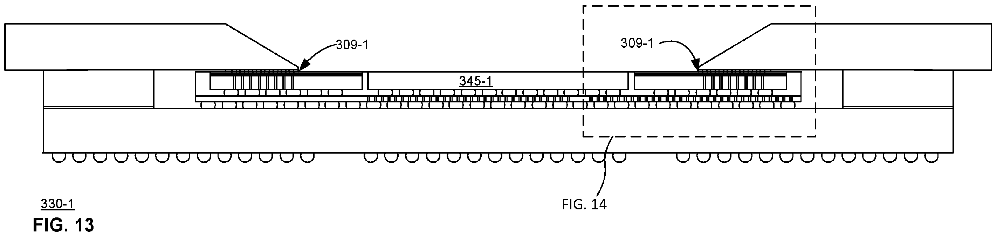

FIGS. 13-14 illustrate photodiodes in sensor array 309-1 of chip package 330-1. FIG. 13, an alternative cross-sectional view taken along line B-B of chip package 330 in FIG. 6, only differs from the prior example in the arrangement of optical chip 334-1 in a face-up position and the absence of an optical interposer. Sensor arrays 309-1 may be positioned directly adjacent microLED arrays 307-1 and overlie front surfaces 333-1 of optical chips 334-1, 335-1.

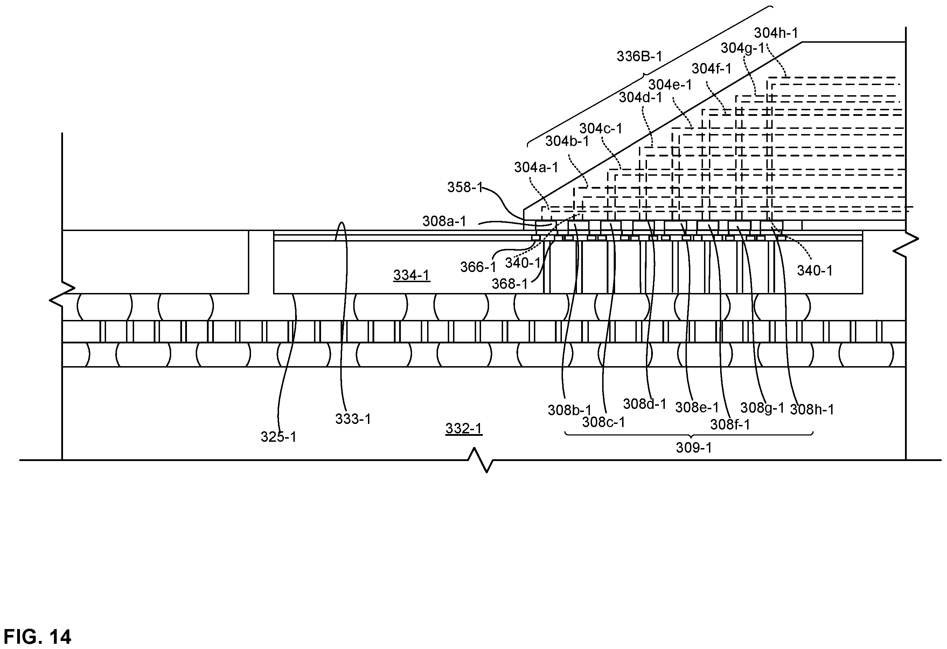

As better seem in FIG. 14, in this cross-section, photodiodes 308-1 (308a-1, 308b-1, 308c-1, 308d-1, 308e-1, 308f-1, 308g-1, 308h-1, collectively "photodiodes 308a-1 through 308h-1" or "photodiodes 308-1") of sensor array 309-1 are shown, but as previously discussed, sensor array 309-1 will include a multiplicity of photodiodes 308-1 and be arranged in additional rows of photodiodes, such that the total number of photodiodes may be more than 10, more than 100, or in the hundreds, thousands, or even more. The number of photodiodes 308a-1 through 308h-1 in sensor array 309-1 can correspond to the number of microLEDs to which it will be connected. Sensor array 309-1 overlies active surface 333-1 of optical chip 334-1, which in this configuration, is the same optical chip 334-1 that microLEDs 306-1 (FIG. 12) overlie. Each photodiode 308a-1 through 308h-1 includes ground terminal 366-1 and power terminal 368-1. In other examples, photodiodes 308a-1 through 308h-1 may be positioned at a surface of a directly adjacent chip, face a rear surface of optical chip 334-1, or be positioned at a surface of substrate 332-1 or another surface.

Photodiodes 308a-1 through 308h-1, as well as all photodiodes in sensor array 309-1 may be connected to microLEDs of a light source array that is external to chip package 330-1, such that photodiodes 308-1 will receive signals from a light source that is external to chip package 330-1. First ends 340-1 of each fiber optic element 304a-1 through 304h-1 in bundle 336B-1 can be directly coupled to photodiodes 308a-1 through 308h-1 (FIG. 14) using known means. In one example, first ends 340-1 may be directly attached to photodiodes 308a-1 through 308h-1, such as a transparent adhesive 358-1. As noted above, fiber optic bundle 336B-1 includes a plurality of single fiber optic elements 304-1 that will join each photodiode in sensor array 309-1. In this cross section, fiber optic elements 304a-1, 304b-1, 304c-1, 304d-1, 304e-1, 304f-1, 304g-1, 304h-1 of light sensor array 309-1 are shown, but it is to be appreciated that there may be more photodiodes in sensor array 309-1 and corresponding fiber optic elements.

A single fiber optic element in fiber optic bundle 336A can be used to coupled or connect each of the microLEDs 306-1 in light source array 307-1 to a corresponding photodiode of the photodiodes in a light sensor array that is external to chip package 330-1, such that microLEDs 306a-1 through 301h-1 and photodiodes 308a-1 through 308h-1 do not directly communicate with one another through fiber optic elements. For example, first end 338-1 of fiber optic element 304a1 can directly connect to a first microLED 306a-1 and a second end of fiber optic element 304a-1 can be directly connected to and attached to a photodiode of a chip package assembly external to chip package 330-1. Each additional microLED 306b-1 through 306h-1 in light source array 307-1 can be similarly connected and paired to an external photodiode in the external light sensor array. In other examples, there may be more microLEDs than photodiodes, such that, for example, two or more microLEDs 306-1 may be connected to external photodiodes or vice versa, such that there is no longer a one-to-one correspondence between each individual pair of microLEDs 306-1 and external photodiodes.

When chip packaging assembly 330-1 is in use, optical interconnect system 300-1 can provide an improved optical interconnection. Optical interconnect system 300-1 can include at least microLEDs 306-1 in light source array 307-1, photodiodes 308-1 in sensor array 309-1, and fiber optic bundle 336A-1. For example, microLED 306a-1 in the light source array 307-1 can receive a signal instructing microLED 306a-1 to turn "on" or remain "on" and emanate light, or to turn "off" or remain "off' and not emanate light or emanate light below a pre-set threshold of light. Fiber optic element 304a-1, which is attached at a first end to microLED 306a-1, transmits a corresponding and unmodulated light signal to an external photodiode of an external chip package assembly that indicates whether microLED 306a-1 is in an "on" state or in an "off" state. The external photodiode can detect whether the light is "on" or "off", as previously described herein.

Photodiode 308a-1 in chip package assembly 330-1 may be coupled to an external microLED of a light source array of a chip package external to chip package assembly 330-1 by fiber optic element 304a-1. Photodiode 308a-1 receives an unmodulated light signal from an external microLED through fiber optic element 304-1 and detects whether the light signal indicates that the external microLED is in an "on" state or in an "off" state. Photodiode 308a-1 may communicate with optical chip 334-1 in order to convert the transmitted light signal into a digital signal. This process may occur for the multiplicity of microLEDs that may be present in the light source array of the external chip package. The timing of the signals received by photodiode 308a-1 may be the same or different, such that some of the microLEDs may be in an "on" state at any given point in time, while other microLEDs may be in an "off" state at any given point in time.

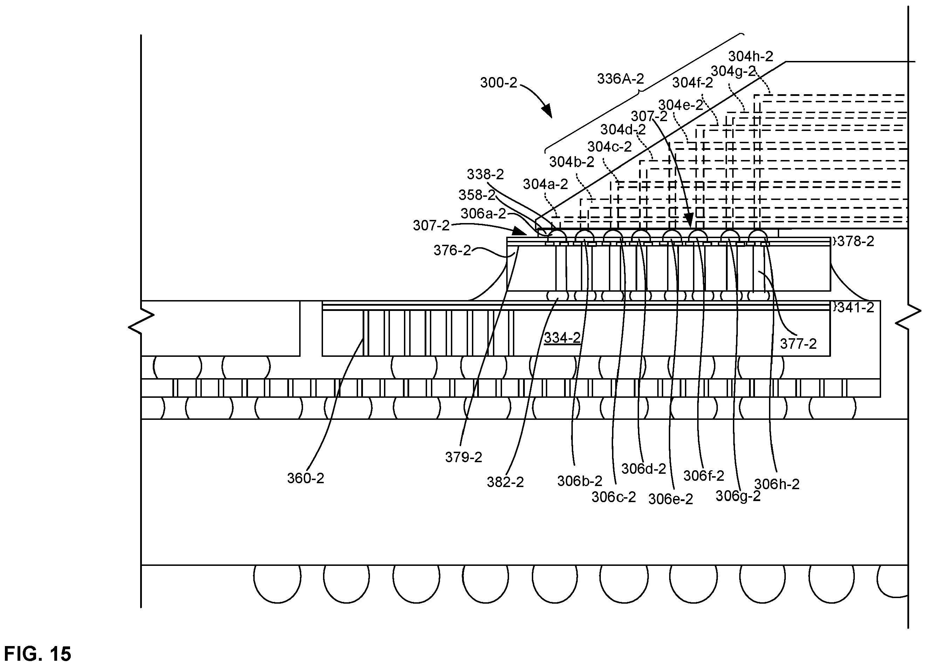

Instead of microLEDs and photodiodes being directly coupled to the front or rear surfaces of a chip, an intermediate interposer may be positioned between the chip and microLED and photodiode arrays. FIG. 15 shows such an arrangement, which is otherwise similar to the arrangement seen in FIGS. 11-12, except for the position of microLEDs 306a-2, 306b-2, 306c-2, 306d-2, 306e-2, 306f-2, 306g-2, 306h-2 (collectively "microLEDs 306a-2 through 306h-2" or "microLEDs 306-2") and photodiodes 308a-2, 308b-2, 308c-2, 308d-2, 308e-2, 308f-2, 308g-2, 308h-2 (collectively "photodiodes 308a-2 through 308h-2" or "photodiodes 308-2") in the chip package assembly 330-2 and the addition of intermediate interposer 376-2 overlying optical chip 334-2. Still referring to FIG. 15, intermediate interposer 376-2 overlies and is bonded to optical chip 334-2 through solder connections, which includes solder balls 382-2. In some examples, intermediate interposer 376-2 may be a carrier wafer with through silicon vias 377-2 and metallization layers 378-2 at its top surface 379-2. Although not shown, metallization layers 378-2 may also be provided at the opposed bottom surface if desired. Interposer 376-2 may be bonded and conductively connected to optical chip 334-2, which further includes vias 360-2
and its own metallization layers 341-2.

MicroLEDs 306a-2 through 306h-2 in light source array 307-2 overlie and are directly coupled to intermediate interposer 376-2, which, in turn, overlies optical chip 334-2. In this example, microLEDs 306-2 may be positioned to overlie chip 334-2 and within metallization layers 378-2 that overlie intermediate interposer 376-2. As shown, microLEDs 306a-2 through 306h-2 may be directly attached to intermediate interposer 376-2 using an adhesive 358-2 that is optically clear. Although not shown, photodiodes 308-2 can be positioned in an array directly adjacent microLEDs 306-2 and overlie and be directly coupled to interposer 376-2, as in previous examples. First ends 338-2 of fiber optic elements 304a-1, 304b-1, 304c-1, 304d-1, 304e-1, 304f-1, 304g-1, 304h-1 (collectively "fiber optic elements 304a-2 through 304h-2" or fiber optic elements 304-2") may be directly attached to microLEDs 306a-2 through 306h-2. The second ends of fiber optic elements 304a-2 through 304h-2, which are not shown, may be attached to external photodiodes of another chip package assembly. The overall incorporation of intermediate interposer 376-2 into the package assembly 330-2, as well as the arrangement of microLEDs 306-2 and photodiodes 308-2, allows for packaging of the optical component 300-2 to be distinct from the packaging of the main optical chip 334-2 and/or any other chips in the package assembly 330-2. This can allow for optical interconnections (e.g., microLEDs, photodiodes, and bundle of fiber optic elements) to be bonded as one of the last steps in the manufacturing process. Other chips in the package assembly may be separately packaged and/or stored, which also makes the manufacturing process easily reproducible and cost effective. It is to be appreciated that the components in assembly 330-2 are similar to those described in FIGS. 11-14 and are not otherwise described for ease of discussion.

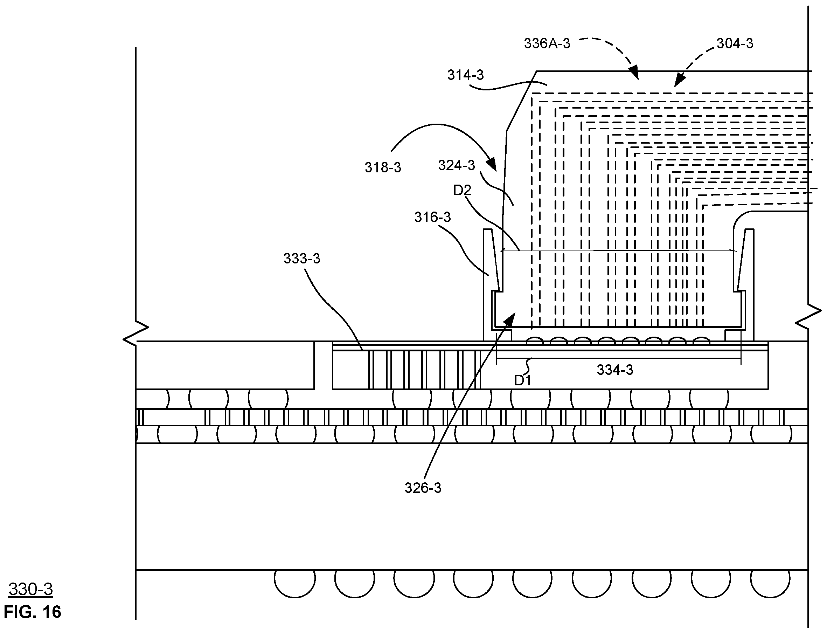

Instead of bonding individual fiber optic elements in a fiber optic bundle directly to the microLEDs using an adhesive or the like, the fiber optic bundle may instead be coupled to the chips using a housing clip. As shown in the schematic example of FIG. 16, an alternative chip package assembly 330-3 is shown. In this example, housing assembly 318-3 can be used to secure fiber optic elements 304-3 of fiber optic bundle 336-3 in alignment with an array 307-3 of microLEDs 306-3. Housing assembly 318-3 can include outer housing 314-3 and housing clip 316-3. Housing clip 316-3 may be attached to a surface supporting microLEDs 306-3 or to another surface at or near the surface supporting microLEDs 306-3. In this example, microLEDs 306-3 are attached to a surface 333-3 of chip 334-3 and housing clip 316-3 may also be attached to a surface of chip 334-3. In other examples, housing clip 316-3 may instead be coupled to another component within chip package assembly 330-3.

Housing 314-3 and housing clip 316-1 may be designed to interlock with one another. In one example, housing 314-3 includes a main body 324-3 that houses fiber optic bundle 336-3 and, in this example, is L-shaped. Housing 314-3 can be an outer shell with an interior opening sized to receive a fiber optic bundle. End portion 322-3 of housing 314-3 has a diameter D1 that is larger than diameter D2 of main body 324-3 so as to create an edge 326-3 extending around end portion 322-2 of housing 314-3. Housing clip 316-3 includes a complementary recess 328-3 for receiving end portion 322-3 of housing 314-3. A lip 329-3 created by recess 328-3 can interlock with edge 326-3 of housing 314-3 to ensure that housing 314-3 is secured to chip package assembly 330-3. In other examples, housing 314-3 may include a recessed area with a lip and housing clip 316-3 may instead have a tab or edge that interlocks with that lip.

As in the previous example, fiber optic elements 304-3 within fiber optic bundle 336-3 may be generally aligned with respective microLEDs 306-3 and external photodiodes of another chip package. As photodiodes need only detect whether the microLED is in an "on" state or in an "off' state, each of the fiber optic elements 304-3 do not need to be precisely aligned with microLEDs 306-3 and external photodiodes. This overall configuration can simplify the manufacturing process and provide for flexibility in product scoping, repairability, and upgradability. It is to be appreciated that the components within FIG. 16 may be the same as previously discussed with regard to FIGS. 9-15 and are not discussed again for brevity and ease of discussion.

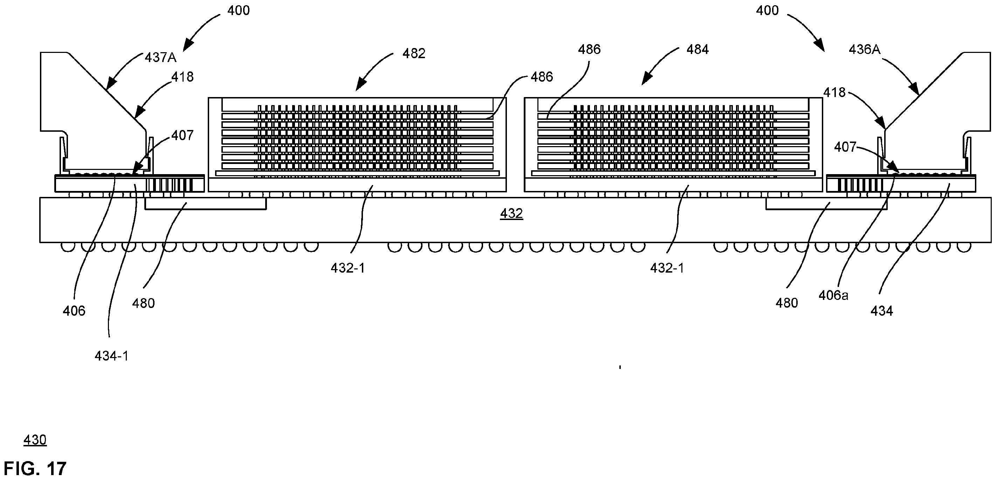

FIG. 17 is another example configuration for a chip packaging assembly 430. Chip packaging assembly 430 includes a substrate 432, a first memory module 482, a second memory module 484, IC chip 434, and optical interconnect system 400, which in this example includes a light source array 407 of microLEDs 406, fiber optic bundles 436A, 437A, and an array of photodiodes not seen in this view. In this example, fiber optic bundles 436A, 437A are coupled to respective chips 434, 434-1 through housing assembly 418 (as previously discussed with regard to FIG. 16), but in other examples, fiber optic bundles 436A, 437A may be directly attached to microLEDs 406 at one end and external photodiodes of an external chip package assembly at another end. First and second memory modules 482, 484 may each include a substrate 432-1 which supports a plurality of memory chips 486. In this example, chips 486 are stacked one on top of the other and electrically interconnected through vias extending at least partially through a portion of each memory chip 486.

First and second memory modules 482, 484 may be conductively connected to optical interconnect system 400 and optical chips 434, 434-1 through a silicon bridge 480. In one example, the silicon bridge may be a silicon material embedded within the substrate and exposed at a top a surface. Silicon bridge 480 may extend laterally between each chip 434,434-1 and corresponding substrate 432. Silicon bridge 480 may be embedded within substrate 432 to provide a high die-to-die or chip-to-chip interconnection.

When chip packaging assembly 430 is in use, each optical interconnect system 400 can include at least microLEDs 406 in light source array 407, photodiodes 408 in sensor array 409, and fiber optic bundle 436. For example, a microLED 406a in the light source array 407 can receive a signal instructing the microLED to turn "on" or remain "on" and emanate light or to turn "off" or remain "off' and to not emanate a predetermined amount of light. A fiber optic element, which is attached at one end to microLED 406a can transmit a corresponding light signal to an external sensor of an external chip package indicating whether microLED 406a is in the "on" state or the "off state." As in the previous examples, an external photodiode receives the light signal and detects whether the light signal indicates that microLED 406a is in an "on" state or in an "off" state. The photodiode may communicate with IC chip 434 and further convert the light signal into an electrical signal. This process may occur for the multiplicity of microLEDs 406 in the light source array 407. The timing may be the same or different, such that some of the microLEDs may be in an "on" state at any given point in time, while other microLEDs may be in an "off" state at any given point in time.

### EXAMPLE CONTROL SYSTEM

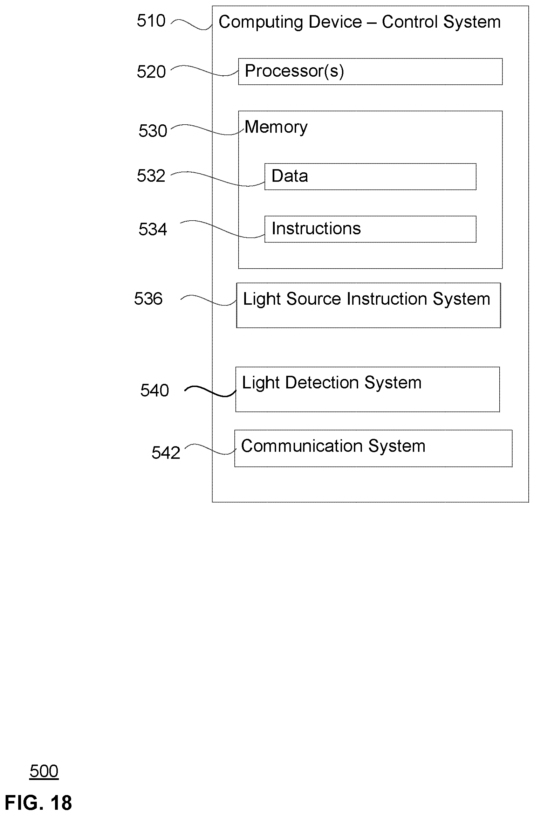

FIG. 18 illustrates an example 500 of a computing device or control system for optical interconnect systems and optical interconnect chip packaging systems, such as the systems shown in FIGS. 1-17. Computing device 510 may contain one or more processors, memory, and other components generally found in general purpose computing devices. As shown in FIG. 18, an optical interconnect system and/or a chip package assembly incorporating such an optical interconnect system may comprise one or more computing devices, such as computing device 510 containing one or more processors 520, memory 530, data 532, instructions 534, and other components typically present in general purpose computing devices.

Memory 530 can store information accessible by the one or more processors 520, including data 532 and instructions 534 that may be executed or otherwise used by the processor 520. Memory 530 may be of any type capable of storing information accessible by the processor, including a computing device-readable medium, or other medium that stores data that may be read with the aid of an electronic device, such as a hard-drive, memory card, ROM, RAM, DVD or other optical disks, as well as other write-capable and read-only memories. Systems and methods may include different combinations of the foregoing, whereby different portions of the instructions and data are stored on different types of media.

Instructions 534 may be any set of instructions to be executed directly (such as machine code) or indirectly (such as scripts) by the processor 520. For example, the instructions 534 may be stored as computing device code on the computing device-readable medium. In that regard, the terms "instructions" and "programs" may be used interchangeably herein. The instructions 534 may be stored in object code format for direct processing by the processor 520, or in any other computing device language including scripts or collections of independent source code modules that are interpreted on demand or compiled in advance. Functions, methods, and routines of the instructions 534 are explained in more detail below.

Data 532 may be retrieved, stored, or modified by processor 520 in accordance with the instructions 534. For instance, although the claimed subject matter is not limited by any particular data structure, the data may be stored in computing device registers, in a relational database as a table having a plurality of different fields and records, XML documents, or flat files. The data may also be formatted in any computing device-readable format.

The one or more processors 520 may be any conventional processors, such as commercially available CPUs. Alternatively, the one or more processors 520 may be a dedicated device such as previously discussed, including without limitation, GPUs, FPGAs, or ASICs, such as TPUs. Although FIG. 18 functionally illustrates the processor, memory, and other elements of computing device 510 as being within the same block, it will be understood by those of ordinary skill in the art that the processor, computing device, or memory may actually include multiple processors, computing devices, or memories that may or may not be stored within the same physical housing. For example, memory 530 may be a hard drive or other storage media located in a housing different from that of computing device 510. Accordingly, references to a processor or computing device will be understood to include references to a collection of processors or computing devices or memory devices that may or may not operate in parallel.

In one example, computing device 510 may be a control system incorporated into the optical interconnect system and/or package assembly. Control system 510 may be capable of communicating with various systems that communicate with optical interconnect systems. Control system 510 can control messages transmitted to and from microLEDs in a chip package assembly, as well as messages that are received by photodiodes in the chip package assembly and then transmitted elsewhere. For example, light source instruction system 536 can individually instruct each light source, such as an LED or microLED 106, 206, 306, 406, in respective light source arrays 107, 207, 307, 407 to be in one of two states: in an "on" state or in an "off' state; light detection system 540 can detect whether the light source is in the "on" state or "off' state; and communication system 542 can communicate the signal indicating whether the light source is in the "on" state or in the "off" state to any other components in the same or different package or device, including, without limitation, other IC chips or ASICs in the same or different chip package.

Control system 510 may initiate activity by receiving a digital signal from light source instruction system 536 that indicates whether LEDs or microLEDs 106, 206, 306, 406 in light source arrays 107, 207, 307, 407 should be in an "on" state and emanating light or in an "off" state, where LEDs or microLEDs 106, 206, 306, 406 are not emanating light. As previously discussed, microLEDs may have two terminals, a ground terminal, such as ground terminals 262, 362, 462, and a power terminal, such as power terminals 264, 364, 464. Ground terminals can be set to a first voltage, such as 0V and the power terminals can be set to a second non-zero voltage, such as 1V, 2V, 5V or the like. The voltage of a single ground terminal 262, 362, 462 may be fixed at 0V in time, whereas the voltage of an individual power terminal 264, 364, 464 will vary over time. This modulation in time may comprise the control system switching the microLED between a zero voltage and a nominal voltage indicating that a digital bit is either a zero ("0") or a one ("1"). When microLEDs, such as one of microLEDs 206, 306, 406, are in an "on" state, corresponding power terminals 264, 364, 464 will have a non-zero voltage and the digital bit is a one ("1"). When a microLED is in an "off" state, corresponding power terminals 264, 364, 464 will have a zero voltage and the digital bit is a zero ("0"). The control system may convert the digital bits to an analog signal, and instruct a driver 112 to drive each corresponding LED or microLED to turn "on" or remain "on" or to turn "off" or remain "off' based on the analog signal.

Each LED or microLED in a chip package may transmit an unmodulated optical light signal through fiber optic elements attached to each LED or microLED. In one example, each LED or microLED transmits a first unmodulated optical signal to a light sensor array of an external chip package or system. Similarly, light sensors in the same chip package, such as photodiodes, are each configured to receive an unmodulated optical signal transmitted from a second external LED or microLED that is external to the chip package. The photodiodes will receive a second unmodulated signal that is connected to individual fiber optic elements. Light detection system 540 may detect the unmodulated optical light signals through light sensors, such as photodiodes 108, 208, 308, 408 previously described herein, that receive the unmodulated optical signals from second light sources, such as LEDs or microLEDs external to the chip package or interconnect system. The photodiodes can convert unmodulated optical light signals to an electrical signal. In other examples, photodiodes 108, 208, 308, 408 can instead be directly connected to each LED or microLED in the same chip package and the photodiodes can convert unmodulated optical light signals received from LEDs or microLEDs in the same chip package to an electrical signal.

Control system 510 can receive the electrical signal and convert the electrical signal to a digital signal that indicates whether the electric signal indicates that the light source is in the "on" state or the "off" state. Based on the information received from the light sensor, such as light sensors 108, 208, 308, 408 in light sensor arrays 109, 209, 309, 409, control system 510 can determine whether light transmitted from microLEDs external to a chip package are in the "on" position or "off" position. Control system 510 can send instructions to the communication system 542 that the light source is in the "on" state. Conversely, if control system 510 determines that the light source is in the "off" state, the control system can transmit instructions to the communication system 542 that the light source is in the "off" state. Thereafter, control system 510 can transmit information to other components within the chip package assembly or other assembly, system, or device. Again, although light source instructions system 536, light detection system 540, and communication system 542 are shown as part of computing device 510, in actuality, one or more of these systems may be a separate system in communication with control system 510.

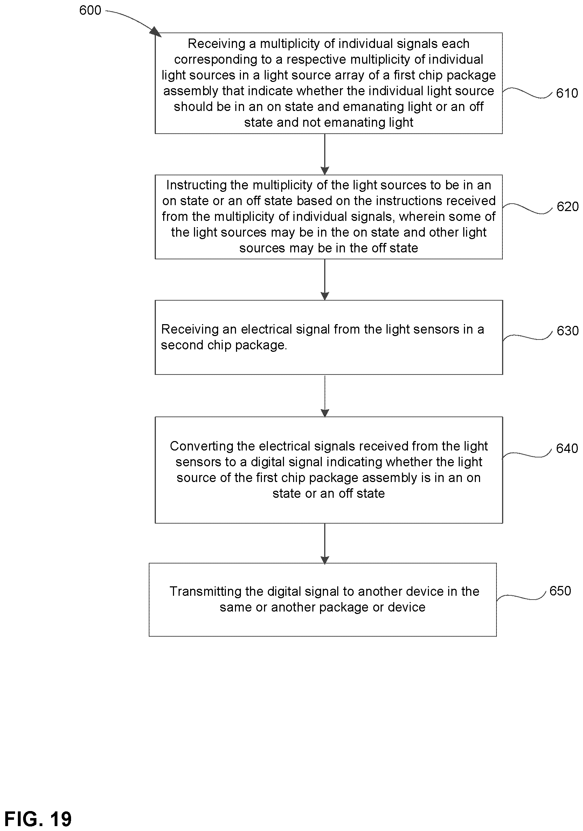

FIG. 19 is an example flow diagram 600 in accordance with some of the aspects described above that may be performed by one or more computing devices such as control system 510. In this example, at block 610, control system 510 receives a multiplicity of individual signals corresponding to a respective multiplicity of individual light sources in a light source array of a first chip package assembly that indicate whether the individual light source should be in an "on" state and emanating light or in an "off' state and not emanating light or emanating light below a predetermined amount.

At block 620, control system 510 instructs the multiplicity of the light sources to be in an "on" state or an "off' state based on the instructions received from the multiplicity of individual signals, wherein some of the light sources may be in the "on" state and other light sources may be in the "off" state.

At block 630, control system 510 receives an electrical signal from the light sensors in a second chip package assembly.

At block 640, control system 510 converts the electrical signals received from the light sensors of the second chip package assembly to a digital signal indicating whether the light source of the first chip package assembly is in an "on" state or an "off" state.

At block 650, control system 510 transmits the digital signal to another device in the same or another package or device.

According to an aspect of the disclosure, a chip package assembly includes a substrate; an integrated circuit ("IC") chip coupled to the substrate; and an optical interconnect system. The optical interconnect system further includes a first optical transmitter and an optical receiver. The first optical transmitter includes a first micro light emitting diode ("microLED") array electrically connected to the IC chip and comprising a plurality of first microLEDs. The first microLEDs has two states comprising a first "on" state and a second "off state. Each of the first microLEDs transmit a first unmodulated optical light signal indicating whether each of the first microLEDs is in the first "on" state or the first "off" state. The optical receiver comprises a light sensor array that further comprises a plurality of light sensors that are configured to sense optical light. Each of the light sensors is configured to receive a second corresponding unmodulated optical light signal from a second external optical transmitter external to the chip package assembly, the second external optical transmitter comprising a plurality of second external microLEDs, wherein each of the second external microLEDs transmits the second corresponding unmodulated optical light signal indicating whether the second external microLED transmitting the second corresponding unmodulated optical light signal is in a second "on" state or a second "off state." The light sensors convert the received and second corresponding unmodulated optical light signal to an electrical signal; and/or
wherein a first fiber optic bundle further includes a plurality of first fiber optic elements, each of the first fiber optic elements having a first end coupled to one of the first microLEDs in the first microLED array; and a second fiber optic bundle further includes a plurality of second fiber optic elements, each of the second fiber optic elements having a first end coupled to one of the light sensors in the light sensor array and a second end coupled to one of the second external microLEDs of the second external optical transmitter. Each of the first microLEDs transmits the first unmodulated optical light signal through a corresponding first fiber optic element of the first fiber optic elements; and/or
wherein each of the second external microLEDs transmits the received and second corresponding unmodulated optical light signal to one of the light sensors through a corresponding second fiber optic element of the plurality of second fiber optic elements coupled to the second external microLEDs. The light sensor is configured to detect whether the second external microLEDs are in the second "on" state or the second "off" state based on the received second corresponding unmodulated optical light signal transmitted through the corresponding second fiber optic element; and/or
wherein each of the first microLEDs transmits a light signal through a corresponding first fiber optic element of the plurality of first fiber optic elements to external light sensors external to the chip package assembly. Each of the light sensors in the chip package assembly is configured to detect whether each of the second microLEDs is in the second "on" state or the second "off" state based on the received and corresponding second unmodulated light signal; and/or.
wherein the first fiber optic elements are each directly attached to the one of the first microLEDs; and/or
wherein the chip package assembly further includes a first cable housing, wherein the first fiber optic bundle is secured within the first cable housing and each of the first ends of the first fiber optic elements are aligned with one of the first microLEDs, the first ends being spaced apart from the first microLEDs; and/or
wherein a number of the first microLEDs in the first microLED array is greater than 100; and/or
wherein when a first microLED of the plurality of first microLEDs is in the first "on" state, the first microLED emits light, and when the first microLED is in the first "off" state, the first microLED does not emit light; and/or
wherein each of the first microLEDs is physically separate from other of the first microLEDs in the first microLED array and each of the light sensors in the light sensor array is physically separate from other of the light sensors in the light sensor array; and/or
wherein one or more of the light sensors in the light sensor array comprise a photodiode; and/or
wherein a state for each of the first microLEDs of the plurality of first microLEDs changes at a rate of 1 GHz or more; and/or
wherein the IC chip is a first chip, and the chip package assembly further comprises a second IC chip. At least one of the one or more of the light sensors transmits the electrical signal to the second IC chip based upon the received and second corresponding unmodulated optical light signal; and/or
wherein the IC chip is a plurality of first IC chips and the chip package assembly further comprises a plurality of second IC chips, and each of the first microLEDs is electrically connected to one of the plurality of first IC chips and each of the light sensors is electrically connected to one of the plurality of second IC chips.; and/or
wherein each of the first microLEDs in the first microLED array comprises a microLED power terminal and a microLED ground terminal, wherein the microLED ground terminal comprises a fixed zero voltage and the microLED power terminal comprises a nominal non-zero voltage that may vary over time. When a current voltage of the microLED power terminal of one of the first microLEDs is at or above the nominal non-zero voltage, the one of the first microLEDs is in an "on state." When the voltage of the microLED power terminal of one of the first microLEDs is below the nominal non-zero voltage, the one of the first microLEDs is in the "off state"; and/or
wherein when the second external optical transmitter is in the second "on" state, the second external optical transmitter emits light, and when the second external optical transmitter is in the "off" state, the second optical transmitter emits no light; and/or
wherein the plurality of light sensors are configured to detect whether each of the plurality of second external microLEDs are in the second "on" state or the second "off" state based on the light signals transmitted through the second fiber optic elements; and/or
wherein two or more of the first microLEDs in the first microLED array of the first chip package assembly are electrically connected to a common carrier, the common carrier overlying an active surface of the first IC chip and having at least two vias extending through a thickness of the common carrier that extends between top and bottom surfaces, the at least two vias connecting the two or more first microLEDs to the IC chip; and/or
wherein the chip package assembly further includes a control device, which includes one or more processors that are configured to: receive the electrical signal from each of the light sensors in the light sensor array; and determine whether the electrical signal received from each of the light sensors indicates that the external second microLED is in the second "on" state or the second "off" state; and/or
wherein the one or more processors are further configured to: receive a multiplicity of individual signals each corresponding to one of the first microLEDs in the first microLED array indicating whether the first microLEDs should be in an "on" state or the "off" state; and instruct each of the first microLEDs in the first microLED array to be in the "on" state or the "off" state;
wherein the IC chip is a high-power chip; and/or
wherein the IC chip is a processing unit; and/or
wherein the processing unit is one of a central processing unit; a graphics processing unit;
a field programmable gate array; or application-specific integrated circuit.

According to another aspect of the disclosure, an optic system for optically interconnecting two or more chip package assemblies comprises the chip package assembly described in paragraph [0134] directly above, and a second chip package assembly. The chip package assembly is a first chip package assembly; the IC chip is a first chip; the light sensor array is a first light sensor array; the plurality of light sensors are a plurality of first light sensors; the optical receiver is a first optical receiver; the electrical signal is a first electrical signal; and the interconnect system is a first interconnect system. The second chip package assembly includes a second IC chip and a second interconnect system. The second interconnect system further includes a second external optical receiver electrically connected to the second IC chip and the second external optical transmitter. The second external optical receiver includes a second external light sensor array comprising a plurality of external second light sensors and the plurality of external second light sensors are configured to sense optical light. The second external optical transmitter may be electrically coupled connected to the second IC chip; and/or
wherein the optic system further includes a first fiber optic bundle that includes a plurality of first fiber optic elements. The first fiber optic bundle couples the light sensors of the first chip package assembly with the second external microLEDs of the second chip package assembly. Each of the second external microLEDs transmits the corresponding second unmodulated optical light signal through a corresponding fiber optic element of the first fiber optic bundle; and/or
wherein a second fiber optic bundle comprising a plurality of second fiber optic elements, the second fiber optic bundle coupling the first microLEDs of the first chip package assembly with the second external light sensors of the second chip package assembly. Each of the first microLEDs transmit the first unmodulated optical light signal to the second external light sensor array through a corresponding second fiber optic element of the second fiber optic elements. The electrical signal of the first chip package is a first electrical signal. The second external light sensors convert the received and second corresponding unmodulated optical light signal to a second electrical signal; and/or
wherein the optic system further includes a third chip package assembly that includes a third IC chip and a third interconnect system. The third interconnect system may further include a third external optical receiver electrically connected to the third IC chip. The third external optical receiver includes a third external light sensor array comprising a plurality of external third light sensors. The plurality of external third light sensors may be configured to sense optical light. The third external optical transmitter may be electrically connected to the third IC chip". The third external optical transmitter includes a third microLED array comprising a plurality of third microLEDs. The third microLEDs have two states comprising a third "on" state and a third "off state. Each of the third microLEDs transmit a third unmodulated optical light signal indicating whether each third microLED is in the third "on" state or the third "off" state. Each of third external light sensors is configured to receive a corresponding first unmodulated optical light signal of the first unmodulated optical light signals transmitted by each of the first microLEDs from a corresponding first microLED of the first microLEDs. The electrical signal of the first chip package is a first electrical signal. The third external light sensors convert the received and first corresponding unmodulated optical light signals to a second electrical signal; and/or
wherein the optic system further includes a second fiber optic bundle comprising a plurality of second fiber optic elements. The second fiber optic bundle couples the first microLEDs of the first chip package assembly with the third external light sensors of the third chip package assembly. Each of the first microLEDs transmit the corresponding first unmodulated optical light signal through a corresponding second fiber optic element of the second fiber optic bundle. The third light sensors convert the received and first corresponding unmodulated optical light signal to another electrical signal; and/or
wherein a number of parallel signal paths of the first fiber optic bundle and/or the second fiber optic bundle and/or the third fiber optic bundle is equal to a number of individual fiber optic elements in the respective first, second, or third fiber optic bundle; and/or
wherein the number of signal paths is greater than 100; and/or
wherein the optic system further comprises one or more processors configured to receive the electrical signal from each of the light sensors in the light sensor array; and determine whether the electrical signal received from each of the light sensors indicates that the external second microLED is in the second "on" state or the second "off" state; and/or
wherein the one or more processors are further configured to receive a multiplicity of individual signals each corresponding to one of the first microLEDs in the first microLED array indicating whether the first microLEDs should be in an "on" state or the "off' state; and instruct each of the first microLEDs in the first microLED array to be in the "on" state or the "off" state;
wherein the first IC chip and/or the second IC chip is a high-power chip; and/or
wherein the first IC chip and/or the second IC chip is a processing unit; and/or
wherein the processing unit is one of a central processing unit; a graphics processing unit; a field programmable gate array; or application-specific integrated circuit.

According to an aspect of the disclosure, an optical interconnect system includes an integrated circuit ("IC") chip; an optical transmitter; an optical transceiver; a fiber optic bundle; and a control device. The optical transmitter includes a light emitting diode ("LED") array electrically connected to the IC chip. Each LED of the LED array has two states including an "on" state and an "off' state. An optical transceiver may include a light sensor array that further includes a plurality of light sensors. Each light sensor in the plurality of light sensors may be configured to sense optical light. The fiber optic bundle includes a plurality of fiber optic elements. Each fiber optic element in the fiber optic bundle pairs an LED in the LED array to a light sensor in the light sensor array, such that each LED in the LED array communicates with a corresponding light sensor in the light sensor array through a single fiber optic element. Each LED in the LED array transmits, through the fiber optic element, an unmodulated optical light signal that indicates whether each LED in the LED array is in an "on" state or an "off' state. Corresponding light sensors in the light sensor array receive the unmodulated optical light signal. Each of the light sensors converts the received and unmodulated optical light signal to an electrical signal. The control device includes one or more processors configured to receive the electrical signal from each of the light sensors in the light sensor array; and determine whether each LED is in the "on" state or the "off" state based on the electrical signal received from each of the light sensors in the sensor array; and/or
wherein the "on" state comprises light emission by the LED and the "off" state comprises no light emission by the LED; and/or
wherein each LED of the LED array comprises a microLED; and/or
wherein each light sensor in the light sensor array comprises a photodiode; and/or
wherein the IC chip is a first chip, and wherein the optical interconnect system further comprises a second IC chip, and at least one of the one or more light sensors transmits a signal to the second IC chip based upon the received optical light signal; and/or
wherein the IC chip is a plurality of first IC chips and the second IC chip is a plurality of second IC chips, and each LED is electrically connected to one of the plurality of first IC chips and each of the light sensors is electrically connected to one of the plurality of second IC chips; and/or
wherein the state for each LED changes at a rate of 1GHz or more; and/or
wherein each LED in the LED array comprises an LED power terminal and an LED ground terminal, wherein the LED ground terminal comprises a fixed zero voltage and the LED power terminal comprises a nominal non-zero voltage that may vary over time, wherein when a voltage of the LED power terminal is at or above a nominal non-zero voltage, the LED is in an "on" state, and when the voltage of the LED power terminal is below the nominal non-zero voltage, the LED is in the "off" state; and/or
wherein the LED transmits a light signal through the fiber optic element to the light sensors, wherein the light sensor is configured to detect whether the LED is in an "on" state or in an "off" state based on the received light signal; and/or
wherein a number of LEDs in the LED array is greater than 100; and/or
wherein each LED in the LED array is physically separate from other LEDs in the LED array and each light sensor in the light sensor array is physically separate from other light sensors in the light sensor array; and/or
wherein the LEDs are bonded to a substrate; and/or
wherein the LEDs are microLEDs bonded to the IC chip; and/or
wherein a length of the fiber optic bundle is greater than 10mm and less than 100mm; and/or
wherein a length of the fiber optic bundle is greater than 100mm and less than 1m; and/or
wherein two or more of the LED devices in the LED array are electrically connected to a common carrier and each other, the common carrier overlying an active surface of the IC chip; and/or
wherein the common carrier is a second substrate having at least two vias extending through a thickness of the common carrier that extends between top and bottom surfaces, the at least two vias connecting the two or more LED devices to the IC chip; and/or
wherein the common carrier is predominantly comprised of silicon; and/or
wherein a number of parallel signal paths is equal to a number of individual fiber optic elements; and/or
wherein the number of signal paths is greater than 100; and/or
wherein the IC chip is a high-power chip; and/or
wherein the IC chip is a processing unit; and/or
wherein the processing unit is one of a central processing unit; a graphics processing unit; a field programmable gate array; or application-specific integrated circuit.

According to an aspect of the disclosure, a chip package assembly includes a substrate and the optical interconnect system as described above in paragraph [0136]. The IC chip is a first chip and overlies the substrate. A second IC chip overlies the substrate and is electrically connected to the light sensor. The light sensor may transmit the electrical signal to the second IC chip;
and/or further comprising a package interposer electrically connecting the first and second IC chips, the package interposer having conductive vias extending through the top and bottom surfaces of the package interposer; and/or
wherein the LEDs are bonded to a rear surface of the first IC chip; and/or
wherein the light sensors are bonded to a rear surface of the first IC chip; and/or
wherein the LEDs are bonded to an active front surface of the first IC chip; and/or
wherein the light sensors are bonded to an active front surface of the first IC chip; and/or
wherein the chip package further comprises a carrier overlying an active front surface of the IC chip, wherein the LEDs are directly attached to a surface of the carrier; and/or
wherein each fiber element is directly attached to a surface of the LEDs; and/or
wherein an optically clear adhesive secures each of the fiber elements to a corresponding surface of the LEDs; and/or
further comprising a cable housing, wherein the fiber optic bundle is secured within the cable housing and first ends of the fiber optic elements of the fiber optic bundle are aligned with the LEDs, the first ends being spaced apart from the LEDs and indirectly attached to the LEDs; and/or
wherein the first IC chip and/or the second IC chip is a high-power chip; and/or
wherein the first IC chip and/or the second IC chip is a processing unit; and/or
wherein the processing unit is one of a central processing unit; a graphics processing unit; a field programmable gate array; or application-specific integrated circuit.

According to another aspect of the disclosure, an optical interconnect system comprises an integrated circuit ("IC") chip; an optical transmitter; an optical transceiver; and a fiber optic bundle. The optical transmitter may include a light emitting diode ("LED") array electrically connected to the IC chip. Each LED of the LED array has an "on" state and an "off' state. An optical transceiver includes a light sensor array that includes a plurality of light sensors. Each light sensor in the plurality of light sensors is configured to sense optical light. A fiber optic bundle may include a plurality of fiber optic elements. Each fiber optic element in the fiber optic bundle pairs an LED in the LED array to a light sensor in the light sensor array, such that each LED in the LED array communicates with a corresponding light sensor in the light sensor array through a single fiber optic element. Each LED in the LED array transmits through the fiber optic element an unmodulated optical light signal indicating whether each LED in the LED array is in an "on" state or an "off' state and corresponding light sensors in the light sensor array receive the unmodulated optical light signal, wherein each of the light sensors convert the received and unmodulated optical light signal to an electrical signal. For each fiber optic element in the plurality of fiber optic elements, a first end of the respective fiber optic element is directly attached to a surface of the LED to which it is connected; and/or
wherein an optically clear adhesive secures the first end of the plurality of fiber optic elements to the surface of the LED; and/or
wherein the "on" state comprises light emission by the LED and the "off" state comprises no light emission by the LED; and/or
wherein each LED of the LED array comprises a microLED and each light sensor in the light sensor array comprises a photodiode; and/or
wherein the IC chip is a first IC chip and the system further comprises a second IC chip, and each LED is electrically connected to first IC chip and each of the light sensors is electrically connected to the second IC chip; and/or
wherein the IC chip is a plurality of first IC chips and a plurality of second IC chips, and each LED is electrically connected to one of the plurality of first IC chips and each of the light sensors is electrically connected to one of the plurality of second IC chips; and/or
wherein the "on" state and the "off' state for each LED changes at a rate of one billion times per second; and/or
wherein each LED in the LED array comprises an LED power terminal and an LED ground terminal, wherein the LED ground terminal comprises a fixed zero voltage and the LED power terminal comprises a nominal non-zero voltage; and/or
wherein when a current voltage of the LED power terminal reaches the nominal non-zero voltage, the LED is in an "on" state and a digital bit is assigned a first number representing that the LED is in the "on" state; and/or
when the current voltage of the LED power terminal is below the nominal non-zero voltage, the digital bit is assigned a second number representing that the LED is in the "off" state; and/or
wherein the first number is a one ("1") and the second number is a zero ("0"); and/or
wherein the LED transmits a light signal through the fiber optic element to the light sensors comprising either the first number or the second number; and/or
wherein the light sensors each include a sensor ground terminal and a sensor power terminal, wherein the sensor ground terminal comprises a zero voltage and the sensor power terminal comprises a sensor nominal non-zero voltage indicating the LED sensor is in the "on" state, wherein the light sensor is configured to detect whether the light signal comprises the first number or the second number based on whether the current light sensor voltage meets the sensor nominal non-zero voltage; and/or
wherein a number of LEDs in the LED array is greater than 100; and/or
wherein a number of LEDs in the LED array is greater than 1000; and/or
wherein each LED in the LED array is physically separate from other LEDs in the LED array; and/or
wherein each light sensor in the light sensor array is physically separate from other light sensors in the light sensor array; and/or
wherein the LEDs are bonded to a substrate; and/or
wherein the LEDs are microLEDs bonded to the IC chip; and/or
wherein two or more of the LED devices in the LED array are electrically connected to a common carrier and each other, the common carrier overlying an active surface of the IC chip; and/or
wherein the common carrier is a second substrate having at least two vias extending through a thickness of the common carrier that extends between top and bottom surfaces, the at least two vias connecting the two or more LED devices to the IC chip; and/or
wherein the common carrier is predominantly comprised of silicon; and/or
wherein a number of parallel signal paths is equal to a number of individual fiber optic elements; and/or
wherein the number of signal paths is greater than 100; and/or
wherein the number of signal paths is greater than 1000; and/or
wherein the IC chip is a first chip, and wherein the optical interconnect system further comprises a second IC chip, and at least one of the one or more light sensors transmits a signal to the second IC chip based upon the received optical light signal; and/or
wherein the IC chip is a plurality of first IC chips and a plurality of second IC chips, and each LED is electrically connected to one of the plurality of first IC chips and each of the light sensors is electrically connected to one of the plurality of second IC chips;
wherein the first IC chip and/or the second IC chip is a high-power chip; and/or
wherein the first IC chip and/or the second IC chip is a processing unit; and/or
wherein the processing unit is one of a central processing unit; a graphics processing unit; a field programmable gate array; or application-specific integrated circuit.

Although the technology herein has been described with reference to particular examples, it is to be understood that these examples are merely illustrative of the principles and applications of the disclosed technology. It is, therefore, to be understood that numerous modifications may be made to the illustrative examples and that other arrangements may be devised without departing from the scope of the present technology as defined by the appended claims. Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including," and the like, should not be interpreted as limiting the subject matter of the claims to the specific examples; rather, the examples are intended to illustrate only one of many possible embodiments. Further, the same or similar series of reference numbers in different drawings can identify the same or similar elements.

## Claims

1. A chip package assembly comprising:
a substrate;
an integrated circuit ("IC") chip coupled to the substrate; and
an optical interconnect system comprising:
a first optical transmitter comprising a first micro light emitting diode ("microLED") array electrically connected to the IC chip and comprising a plurality of first microLEDs, the first microLEDs having two states comprising a first "on" state and a second "off state, and each of the first microLEDs transmitting a first unmodulated optical light signal indicating whether each of the first microLEDs is in the first "on" state or the first "off" state; and
an optical receiver comprising a light sensor array comprising a plurality of light sensors, the light sensors configured to sense optical light,
wherein each of the light sensors is configured to receive a second corresponding unmodulated optical light signal from a second external optical transmitter external to the chip package assembly, the second external optical transmitter comprising a plurality of second external microLEDs, wherein each of the second external microLEDs transmits the second corresponding unmodulated optical light signal indicating whether the second external microLED transmitting the second corresponding unmodulated optical light signal is in a second "on" state or a second "off state," and
wherein the light sensors convert the received and second corresponding unmodulated optical light signal to an electrical signal.

2. The chip package assembly of claim 1, further comprising:
a first fiber optic bundle comprising a plurality of first fiber optic elements, each of the first fiber optic elements having a first end coupled to one of the first microLEDs in the first microLED array; and
a second fiber optic bundle comprising a plurality of second fiber optic elements, each of the second fiber optic elements having a first end coupled to one of the light sensors in the light sensor array and a second end coupled to one of the second external microLEDs of the second external optical transmitter,
wherein each of the first microLEDs transmits the first unmodulated optical light signal through a corresponding first fiber optic element of the first fiber optic elements.

3. The chip package assembly of claim 2, wherein each of the second external microLEDs transmits the received and second corresponding unmodulated optical light signal to one of the light sensors through a corresponding second fiber optic element of the plurality of second fiber optic elements coupled to the second external microLEDs, and
wherein the light sensor is configured to detect whether the second external microLEDs are in the second "on" state or the second "off" state based on the received and second corresponding unmodulated optical light signal transmitted through the corresponding second fiber optic element.

4. The chip package assembly of claim 2 or 3, wherein each of the first microLEDs transmits a light signal through a corresponding first fiber optic element of the plurality of first fiber optic elements to external light sensors external to the chip package assembly, and
wherein each of the light sensors in the chip package assembly is configured to detect whether each of the second microLEDs is in the second "on" state or the second "off" state based on the received and corresponding second unmodulated light signal.

5. The chip package assembly of one of claims 2 to 4, wherein the first fiber optic elements are each directly attached to the one of the first microLEDs.

6. The chip package assembly of one of claims 2 to 5, further comprising a first cable housing, wherein the first fiber optic bundle is secured within the first cable housing and each of the first ends of the first fiber optic elements are aligned with one of the first microLEDs, the first ends being spaced apart from the first microLEDs.

7. The chip package assembly of one of claims 1 to 6, wherein when a first microLED of the plurality of first microLEDs is in the first "on" state, the first microLED emits light, and when the first microLED is in the first "off" state, the first microLED does not emit light.

8. The chip package assembly of one of claims 1 to 7, wherein a number of the first microLEDs in the first microLED array is greater than 100; and/or
wherein each of the first microLEDs is physically separate from other of the first microLEDs in the first microLED array and each of the light sensors in the light sensor array is physically separate from other of the light sensors in the light sensor array; and/or
wherein one or more of the light sensors in the light sensor array comprise a photodiode and the IC chip comprises a processor unit; and/or
wherein a state for each of the first microLEDs of the plurality of first microLEDs changes at a rate of 1 GHz or more; and/or
wherein the IC chip is a first chip, and wherein the chip package assembly further comprises a second IC chip, and at least one of the one or more of the light sensors transmits the electrical signal to the second IC chip based upon the received and second corresponding unmodulated optical light signal.

9. The chip package assembly of one of claims 1 to 8, wherein each of the first microLEDs in the first microLED array comprises a microLED power terminal and a microLED ground terminal, wherein the microLED ground terminal comprises a fixed zero voltage and the microLED power terminal comprises a nominal non-zero voltage that may vary over time,
wherein when a current voltage of the microLED power terminal of one of the first microLEDs is at or above the nominal non-zero voltage, the one of the first microLEDs is in an "on state," and
wherein when the current voltage of the microLED power terminal of one of the first microLEDs is below the nominal non-zero voltage, the one of the first microLEDs is in the "off state."

10. The chip package assembly of one of claims 1 to 9, wherein when the second external optical transmitter is in the second "on" state, the second external optical transmitter emits light, and when the second external optical transmitter is in the "off" state, the second external optical transmitter emits no light.

11. The chip package assembly of one of claims 1 to 10, wherein the chip package assembly further comprises a control device, the control device including one or more processors configured to:
receive the electrical signal from each of the light sensors in the light sensor array; and
determine whether the electrical signal received from each of the light sensors indicates that the external second microLED is in the second "on" state or the second "off" state; and/or
wherein the one or more processors are further configured to:
receive a multiplicity of individual signals each corresponding to one of the first microLEDs in the first microLED array indicating whether the first microLEDs should be in an "on" state or the "off' state; and
instruct each of the first microLEDs in the first microLED array to be in the "on" state or the "off" state.

12. An optic system for interconnecting one or more chip package assemblies comprising:
the chip package assembly of claim 1, wherein the chip package assembly is a first chip package assembly, the IC chip is a first chip, the light sensor array is a first light sensor array, the plurality of light sensors are a plurality of first light sensors, the optical receiver is a first optical receiver, the electrical signal is a first electrical signal, and the optical interconnect system is a first interconnect system;
a second chip package assembly comprising:
a second IC chip;
a second optical interconnect system comprising:
a second external optical receiver electrically connected to the second IC chip, the second external optical receiver comprising a second external light sensor array comprising a plurality of external second light sensors, the plurality of external second light sensors configured to sense optical light;
the second external optical transmitter; the second external optical transmitter electrically connected to the second IC chip.

13. The optic system of claim 12, further comprising a first fiber optic bundle comprising a plurality of first fiber optic elements, the first fiber optic bundle coupling the light sensors of the first chip package assembly with the second external microLEDs of the second chip package assembly, and
wherein each of the second external microLEDs transmits the corresponding second unmodulated optical light signal through a corresponding fiber optic element of the first fiber optic bundle.

14. The optic system of claim 13 further comprising a second fiber optic bundle comprising a plurality of second fiber optic elements, the second fiber optic bundle coupling the first microLEDs of the first chip package assembly with the second external light sensors of the second chip package assembly,
wherein each of the first microLEDs transmit the first unmodulated optical light signal to the second external light sensor array through a corresponding second fiber optic element of the second fiber optic elements, and
wherein the electrical signal is a first electrical signal, and the second external light sensors convert the received and second corresponding unmodulated optical light signal to a second electrical signal.

15. The optic system of one of claims 12 to 14, further comprising
a third chip package assembly comprising:
a third IC chip;
a third interconnect system comprising:
a third external optical receiver electrically connected to the third IC chip, the third external optical receiver comprising a third external light sensor array comprising a plurality of external third light sensors, the plurality of external third light sensors configured to sense optical light;
a third external optical transmitter electrically connected to the third IC chip", the third external optical transmitter comprising a third microLED array comprising a plurality of third microLEDs,
the third microLEDs having two states comprising a third "on" state and a third "off state, and each of the third microLEDs transmitting a third unmodulated optical light signal indicating whether each third microLED is in the third "on" state or the third "off" state,
wherein each of third external light sensors is configured to receive a corresponding first unmodulated optical light signal of the first unmodulated optical light signals transmitted by each of the first microLEDs from a corresponding first microLED of the first microLEDs, and
wherein the electrical signal is a first electrical signal and the third external light sensors convert the received and first corresponding unmodulated optical light signal to a second electrical signal.
